(19) **Europäisches Patentamt / European Patent Office / Office européen des brevets**

(11) **EP 4 056 516 B1**

(12) **FASCICULE DE BREVET EUROPEEN**

(45) Date de publication et mention de la délivrance du brevet:
**07.05.2025   Bulletin 2025/19**

(21) Numéro de dépôt: **22160130.5**

(22) Date de dépôt: **04.03.2022**

(51) Classification Internationale des Brevets (IPC):
***B66C 13/12*** *(2006.01)*

(52) Classification Coopérative des Brevets (CPC):
**B66C 13/12**

(54) **PROCÉDÉ DE GESTION D'ALIMENTATION ÉLECTRIQUE D'UNE GRUE À PARTIR D'UNE SOURCE PRIMAIRE ET D'UNE SOURCE SECONDAIRE RECHARGEABLE**

VERFAHREN ZUR STEUERUNG DER STROMVERSORGUNG EINES KRANS AUS EINER PRIMÄRQUELLE UND EINER WIEDERAUFLADBAREN SEKUNDÄRQUELLE

METHOD FOR MANAGING THE POWER SUPPLY OF A CRANE FROM A PRIMARY SOURCE AND A RECHARGEABLE SECONDARY SOURCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:   **10.03.2021   FR 2102360**

(43) Date de publication de la demande:
**14.09.2022   Bulletin 2022/37**

(73) Titulaire: **Manitowoc Crane Group France 69570 Dardilly (FR)**

(72) Inventeurs:
• **RONI-DAMOND, Bruno**
  **69002 LYON (FR)**
• **VEILLEROT, Vincent**
  **69160 TASSIN LA DEMI LUNE (FR)**

(74) Mandataire: **Germain Maureau**
  **12, rue Boileau**
  **69006 Lyon (FR)**

(56) Documents cités:
| EP-A1- 1 927 570 | EP-A1- 1 967 486 |
| WO-A1-2013/001674 | WO-A1-2015/032320 |
| WO-A2-2012/084508 | CN-A- 104 555 742 |

# Description

## [Domaine Technique de l'invention]

La présente invention concerne un procédé de gestion d'alimentation électrique pour alimenter électriquement des équipements électriques d'une grue à partir d'une source d'alimentation primaire comme le réseau électrique et d'une source d'alimentation secondaire rechargeable comme une batterie via un circuit de conversion, ainsi qu'une grue mettant en œuvre ce procédé de gestion.

## [Technique antérieure]

La puissance d'alimentation fournie par une source d'énergie électrique pour alimenter une grue est souvent limitée. La source d'énergie électrique peut même ne pas être présente à proximité de la grue, en particulier lors de l'installation de la grue sur un chantier. C'est le cas notamment pour les Grues à Montage Automatisé GMA conçues pour des petits chantiers de construction ou de rénovation, et pour lesquelles la source d'énergie électrique disponible sur le chantier, qui peut désigner le réseau électrique ou bien un groupe électrogène par exemple, peut fournir différentes valeurs de tensions électriques par exemple une tension 400V triphasé, une tension 230V monophasé avec un courant électrique de 20A ou 32A.

Ainsi, pour pouvoir alimenter la grue, un utilisateur de la grue est contraint de dimensionner la source d'énergie électrique en tenant compte du besoin d'énergie électrique minimal de la grue.

Le coût pour fournir une source d'alimentation électrique adéquate est proportionnel à la puissance d'alimentation demandée et augmente considérablement si la grue nécessite une nouvelle installation de réseau électrique apte à fournir une plus grande puissance d'alimentation ou bien si la grue nécessite une utilisation d'un groupe électrogène.

Une solution connue pour limiter le coût dû à la source l'alimentation d'une grue est de diminuer le besoin minimal en puissance d'alimentation électrique de la grue en réduisant sa performance, en général en choisissant un treuil de levage plus petit requérant pour fonctionner un courant électrique moindre. Dans ce cas, la baisse de performance et de productivité est considérable pour la grue.

Une autre solution consiste à rajouter à la source d'alimentation primaire une source d'alimentation auxiliaire ou secondaire rechargeable pour augmenter la puissance d'alimentation fournie à la grue.

Ainsi, il est connu de mettre en œuvre un procédé de gestion d'alimentation électrique pour alimenter électriquement des équipements électriques d'une grue à partir d'une source d'alimentation primaire apte à fournir une puissance primaire et d'une source d'alimentation secondaire rechargeable apte à fournir une puissance secondaire via un circuit de conversion.

Le document CN202004500U propose par exemple l'emploi pour un dispositif de levage comme une grue d'une source d'alimentation secondaire rechargeable, autrement dit d'une source d'alimentation autonome sur batteries, avec convertisseur, et évoque une fonction d'alimentation de secours en cas de défaillance de la source d'alimentation primaire.

Le document CN110963412A propose aussi l'emploi d'une source autonome sur batteries, avec convertisseur, et évoque un mode d'alimentation hybride dans lequel la source d'alimentation primaire et la source d'alimentation secondaire rechargeable sont toutes deux connectées aux équipements électriques d'une grue pour les alimenter électriquement.

Le document WO 2013/001674 A1 propose un procédé de gestion d'alimentation électrique selon le préambule de la revendication 1.

Ces dispositions donnent satisfaction en ce qu'il devient possible de fournir un complément de puissance d'alimentation ou d'assurer un relais de puissance d'alimentation lors d'une coupure ou d'une défaillance de la source d'alimentation primaire.

Toutefois les procédés de gestion d'alimentation électrique existants ne permettent pas un pilotage automatique d'une distribution de puissance en provenance de la source d'alimentation primaire lorsque la demande de puissance d'alimentation des équipements électriques de la grue dépasse un seuil de puissance maximal disponible par la source d'alimentation primaire.

## [Description Générale]

La présente invention a pour but de résoudre tout ou partie des inconvénients mentionnés ci-dessus.

Le problème technique à la base de l'invention consiste notamment à mettre en oeuvre un procédé de gestion d'alimentation électrique pour alimenter électriquement des équipements électriques d'une grue remarquable en ce que ledit procédé comprend une surveillance d'une puissance générale demandée qui correspond à une puissance demandée par l'ensemble des équipements électriques, et une surveillance d'un niveau de charge de la source d'alimentation secondaire rechargeable, et à fournir la grue pour laquelle est mise en œuvre ce procédé de gestion qui soit de structure simple et économique.

A cet effet, la présente invention a pour objet un procédé de gestion d'alimentation électrique pour alimenter électriquement des équipements électriques d'une grue, via un circuit de conversion, à partir d'une source d'alimentation primaire apte à fournir une puissance primaire et d'une source d'alimentation secondaire rechargeable apte à fournir une puissance secondaire selon le type précité, remarquable en ce que comprend une surveillance d'une puissance générale demandée qui correspond à une puissance demandée par l'ensemble des équipements électriques, et une surveillance d'un niveau de charge de la source d'alimentation secondaire rechargeable, et dans lequel le procédé de gestion d'alimentation électrique met en oeuvre, en fonction de ladite puissance générale demandée et dudit niveau de charge, au moins les modes de gestion suivants :

- un mode de recharge dans lequel la puissance générale demandée est nulle et la source d'alimentation primaire est disponible et connectée à la source d'alimentation secondaire rechargeable pour la recharger selon son niveau de charge ;
- un mode mixte recharge/alimentation dans lequel la puissance générale demandée est non nulle, et la source d'alimentation primaire est disponible et connectée, d'une part, aux équipements électriques pour les alimenter électriquement et, d'autre part, à la source d'alimentation secondaire rechargeable pour la recharger selon le niveau de charge ;
- un mode d'alimentation principale dans lequel la puissance générale demandée est non nulle, et seule la source d'alimentation primaire est connectée aux équipements électriques pour les alimenter électriquement ;
- un mode d'alimentation hybride dans lequel la puissance générale demandée est non nulle, et la source d'alimentation primaire et la source d'alimentation secondaire rechargeable sont toutes deux connectées aux équipements électriques pour les alimenter électriquement ; et
- un mode d'alimentation autonome dans lequel la puissance générale demandée est non nulle, et seule la source d'alimentation secondaire est connectée aux équipements électriques pour les alimenter électriquement selon le niveau de charge.

La source d'alimentation primaire peut par exemple désigner le réseau électrique et/ou un groupe électrogène, et la source d'alimentation secondaire rechargeable peut par exemple désigner une ou plusieurs batteries rechargeables.

Par ailleurs, dans le procédé de gestion d'alimentation électrique décrit selon l'invention, les équipements électriques sont alimentées par une puissance maximale disponible qui correspond au minimum entre une puissance de conversion maximale et une puissance source, où la puissance de conversion maximale correspond à une puissance maximale pouvant être délivrée en sortie du circuit de conversion et où la puissance source correspond à :

- la somme de la puissance secondaire et de la puissance primaire dans le mode d'alimentation hybride,
- la puissance secondaire dans le mode d'alimentation autonome ;
- la puissance primaire dans le mode d'alimentation principale ; et
- la puissance primaire moins une puissance de recharge servant à recharger la source d'alimentation secondaire rechargeable dans le mode mixte recharge/alimentation ;

et où le procédé de gestion d'alimentation électrique met en œuvre, dans le mode d'alimentation autonome et dans le mode d'alimentation hybride, une adaptation de la puissance secondaire en fonction au moins du niveau de charge, ladite puissance secondaire étant inférieure ou égale à une puissance maximale secondaire qui correspond à une puissance maximale pouvant être délivrée par la source d'alimentation secondaire rechargeable.

Ainsi, l'invention propose d'adapter la puissance secondaire fournie par la source d'alimentation secondaire rechargeable en fonction de son niveau de charge, permettant ainsi d'améliorer, voire économiser, la gestion de l'énergie électrique en provenance de cette source d'alimentation secondaire rechargeable.

Le procédé de gestion d'alimentation électrique met en oeuvre une sélection, dans le mode d'alimentation hybride et dans le mode d'alimentation autonome, d'un sous-mode de gestion parmi plusieurs sous-modes de gestion comprenant au moins :

- un sous-mode automatique dans lequel la puissance secondaire est contrôlée pour correspondre à ka fois la puissance maximale secondaire, où ka est un coefficient qui est inférieur ou égal à 1 et qui diminue avec le niveau de charge jusqu'à ce que le niveau de charge passe en-dessous d'un seuil bas ;
- un sous-mode économique dans lequel la puissance secondaire est contrôlée pour correspondre à ke fois la puissance maximale secondaire, où ke est un coefficient inférieur à ka et qui diminue avec le niveau de charge jusqu'à ce que le niveau de charge passe en-dessous d'un seuil bas.

Dans le procédé de gestion d'alimentation électrique décrit et selon un mode de mise en oeuvre :

- dans le sous-mode automatique, le coefficient ka est égal à kamax tant que le niveau de charge de la source d'alimentation secondaire rechargeable est au-dessus d'un seuil haut, puis le coefficient ka est égal à kamin lorsque le niveau de charge est compris entre le seuil bas et le seuil haut, et enfin le coefficient ka est nul lorsque le niveau de charge de la source d'alimentation secondaire rechargeable est en-dessous du seuil bas, où kamax est supérieur kamin ; et
- dans le sous-mode économique, le coefficient ke est égal à kemax tant que le niveau de charge de la source d'alimentation secondaire rechargeable est au-dessus du seuil haut, puis le coefficient ke est égal à kemin lorsque le niveau de charge de la source d'alimentation secondaire rechargeable est compris entre le seuil bas et le seuil haut, et enfin le coefficient ke est nul lorsque le niveau de charge de la source d'alimentation secondaire rechargeable est en-dessous du seuil bas, où kemax est supérieur kemin, kamax est supérieur à kemax et kamin est supérieur kemin.

Selon une possibilité, kamax est compris entre 0,8 et 1, kamin est compris entre 0,5 et 0,7, kemax est compris entre 0,6 et 0,8 et kemin est compris entre 0,2 et 0,4.

Le seuil bas est compris entre 5 et 15 % d'une capacité de charge de la source d'alimentation secondaire rechargeable et le seuil haut est compris entre 40 et 60 % d'une capacité de charge de la source d'alimentation secondaire rechargeable.

Dans le mode d'alimentation autonome et que ce soit dans le sous-mode automatique ou dans le sous-mode économique, le procédé de gestion d'alimentation électrique peut passer automatiquement dans un mode de veille après que le niveau de charge de la source d'alimentation secondaire rechargeable soit passé en-dessous du seuil bas, où dans le mode de veille sont alimentés uniquement des équipements de sécurité prédéfinis parmi les équipements électriques pour permettre une mise en sécurité de la grue, et en particulier une mise en girouette d'une flèche de la grue.

Dans le mode de veille, la puissance secondaire peut être contrôlée pour correspondre à la puissance maximale secondaire afin d'alimenter les équipements de sécurité au moins le temps de la mise en sécurité de la grue (comme par exemple de la mise en girouette).

Selon une possibilité, les sous-modes de gestion comprennent également un sous-mode extrême dans lequel la puissance secondaire correspond à la puissance maximale secondaire quel que soit la valeur du niveau de charge de la source d'alimentation secondaire rechargeable.

Dans le sous-mode extrême, lorsque le niveau de charge de la source d'alimentation secondaire rechargeable est passé en-dessous du seuil bas alors peuvent être alimentés uniquement les équipements de sécurité pour permettre une mise en sécurité de la grue.

Un procédé de répartition de la puissance maximale disponible sur les différents équipements électriques peut être mis en œuvre, quel que soit le mode de gestion parmi le mode d'alimentation hybride, le mode d'alimentation autonome, le mode d'alimentation principale et le mode mixte recharge/alimentation.

Selon une possibilité, le procédé de répartition de la puissance maximale comprend une étape de sélection entre :

- un mode brut dans lequel la puissance maximale disponible est répartie sur des équipements d'actionnement prédéfinis et sur des équipements accessoires prédéfinis parmi les équipements électriques, les équipements d'actionnement sont définis en fonction d'une configuration de la grue ; et

- un mode optimisé dans lequel la puissance maximale disponible est répartie sur les équipements d'actionnement prédéfinis, et aussi sur les équipements accessoires mais en fonction de conditions de coupure associées aux équipements accessoires, de sorte que selon leurs conditions de coupure respectives les équipements accessoires sont alimentés ou non.

Ainsi, ce procédé de répartition propose de faire une distinction entre :

- les équipements d'actionnement qui sont les équipements propres à actionner un déplacement de la grue ou d'un élément de la grue, et en particulier pour le montage/démontage de la grue et pour le déplacement d'une charge ; et
- les équipements accessoires qui sont les équipements qui ne sont pas des équipements d'actionnement, autrement dit des équipements qui ne participent pas au déplacement de la grue ou d'un élément de la grue.

Il est bien évident que les équipements électriques comprennent les équipements d'actionnement et les équipements accessoires.

Ce procédé de répartition propose ensuite de sélectionner entre :

- le mode brut dans lequel la puissance maximale disponible est répartie sur les équipements d'actionnement et sur les équipements accessoires, sans distinction entre les équipements d'actionnement et les équipements accessoires, du moment que l'équipement électrique est en demande de puissance électrique ; et
- le mode optimisé dans lequel la puissance maximale disponible est répartie sur les équipements d'actionnement, et aussi sur les équipements accessoires mais seulement en fonction de conditions de coupure.

Si, pour un équipement accessoire, sa condition de coupure est remplie pour qu'il y ait une coupure de l'équipement accessoire, alors dans le mode optimisé cet équipement accessoire ne sera pas alimentée électriquement. Par contre, si pour un équipement accessoire, sa condition de coupure n'est pas remplie pour qu'il y ait une coupure de l'équipement accessoire, alors dans le mode optimisé cet équipement accessoire sera alimentée électriquement. Dans le mode optimisé, il n'y a par contre pas de condition de coupure pour les équipements d'actionnement, qui sont donc prioritaires.

Les équipements d'actionnement peuvent comprendre des équipements de montage qui participent au montage de la grue en actionnant un déplacement d'une ou plusieurs parties de la grue lorsque la grue est dans une configuration de montage.

Les équipements d'actionnement peuvent comprendre des équipements de travail qui participent au déplacement d'une charge lorsque la grue est dans une configuration de travail.

Les équipements de montage peuvent comprendre l'un au moins des équipements suivants : une centrale hydraulique de pliage/dépliage permettant un pliage/dépliage d'un mât et d'une flèche, une centrale hydraulique de calage permettant un calage de la grue au sol, une centrale hydraulique d'orientation permettant une orientation d'une base de la grue, une centrale hydraulique de potence permettant un actionnement d'une potence de montage.

Les équipements de travail peuvent comprendre l'un au moins des équipements suivants : un système motorisé de levage permettant un levage/abaissement d'une charge, un système motorisé de distribution permettant une distribution d'une charge le long d'une flèche, un système motorisé d'orientation permettant une orientation d'une flèche, un système motorisé de translation permettant une translation de la grue, un système motorisé de relevage permettant un relevage d'une flèche relevable.

Les équipements accessoires peuvent comprendre l'un au moins des équipements accessoires de système suivants : un système de chauffage pour chauffer un espace de la grue, un système de ventilation ou de refroidissement pour ventiler/refroidir un espace de la grue ; et les conditions de coupure dépendent d'au moins un paramètre environnemental qui est un paramètre physique représentatif de l'espace de la grue.

Ainsi, parmi les équipements accessoires, on trouve les équipements accessoires de système associés à des espaces de la grue et qui, dans le mode optimisé, seront coupés ou pas en fonction au moins du paramètre environnemental associé à l'espace correspondant.

Le paramètre environnemental peut être une température intérieure de l'espace de la grue.

Selon une possibilité, l'espace de la grue correspond à une armoire électrique regroupant intérieurement tout ou partie des organes participant à l'alimentation électrique de la grue, ou à une cabine de pilotage.

Les équipements accessoires peuvent comprendre l'un au moins des équipements accessoires d'utilisateur suivants : un système d'éclairage, une prise électrique ; et les conditions de coupure dépendent d'une sélection d'une classification opérée par un utilisateur pour le ou chacun des équipements accessoires d'utilisateur, parmi les classifications suivantes :

- une classification « non essentielle » qui correspond à une autorisation de ne pas alimenter l'équipement accessoire utilisateur correspondant en mode optimisé au profit des équipements d'actionnement ; et
- une classification « essentielle » qui correspond à une interdiction de ne pas alimenter l'équipement accessoire utilisateur correspondant en mode optimisé.

Ainsi, parmi les équipements accessoires, on trouve les équipements accessoires d'utilisateur, qui sont eux-mêmes diviser en deux classes, une classe « non essentielle » et une classe « essentielle ».

Dans le mode optimisé, les équipements d'actionnement peuvent être alimentées par une puissance d'actionnement qui est équivalente à la puissance maximale disponible ou à la puissance maximale disponible diminuée d'une puissance accessoire nécessaire pour alimenter les équipements accessoires selon les conditions de coupure, et cette puissance d'actionnement est répartie sur les équipements d'actionnement selon un schéma de répartition sélectionné parmi les deux schémas de répartition suivants :

- un premier schéma dans lequel les équipements d'actionnement sont activés et donc alimentés de manière séquentielle, de sorte que chaque équipement d'actionnement est alimenté, lorsque activé, par la puissance d'actionnement ; et
- un second schéma dans lequel les équipements d'actionnement sont activés et donc alimentés en simultané, de sorte que tous les équipements d'actionnement sont alimentés ensemble par la puissance d'actionnement.

Selon une possibilité, un stockage est mis en œuvre dans une mémoire d'une pluralité de modes de répartition préférentielle, chaque mode de répartition préférentielle étant associé à des pourcentages de répartition de la puissance d'actionnement sur les différents équipements d'actionnement dans le second schéma, et le procédé de gestion d'alimentation électrique met en œuvre une sélection d'un mode de répartition préférentielle pour assurer une répartition de la puissance d'actionnement conformément audit mode de répartition préférentielle sélectionné lorsque le second schéma est sélectionné.

Lorsque la puissance générale demandée est non nulle, les modes de gestion suivants peuvent être automatiquement mis en œuvre :

- le mode d'alimentation autonome est automatiquement mis en œuvre si la source d'alimentation primaire n'est pas disponible ;
- le mode d'alimentation principale ou le mode mixte recharge/alimentation est automatiquement mis en œuvre en fonction du niveau de charge de la source d'alimentation secondaire rechargeable, si la source d'alimentation est disponible et si la puissance générale demandée est inférieure à la puissance primaire ;
- le mode d'alimentation hybride est automatiquement mis en œuvre si la source d'alimentation est disponible et si la puissance générale demandée est supérieure à la puissance primaire.

La source d'alimentation primaire peut délivrer une tension d'alimentation primaire de type monophasée ou triphasée, par exemple en 230 ou 400 volts, et le circuit de conversion assure une conversion de ladite tension d'alimentation primaire en une tension d'alimentation triphasée.

La présente invention a également pour objet une grue comprenant des équipements électriques alimentés électriquement, via un circuit de conversion, par une source d'alimentation primaire apte à fournir une puissance primaire et une source d'alimentation secondaire rechargeable apte à fournir une puissance secondaire remarquable en ce que ladite grue comprend une unité de surveillance d'une puissance générale demandée qui correspond à une puissance demandée par l'ensemble des équipements électriques et d'un niveau de charge de la source d'alimentation secondaire rechargeable, et en ce qu'elle comprend une unité de contrôle/commande, raccordée à l'unité de surveillance et au circuit de conversion, et configurée pour mettre en œuvre le procédé de gestion d'alimentation électrique.

Dans la grue, les équipements électriques peuvent comprendre des équipements de sécurité configurés pour permettre une mise en sécurité de la grue.

Les équipements électriques peuvent comprendre des équipements accessoires comme par exemple un système de chauffage pour chauffer un espace de la grue, un système de ventilation ou de refroidissement pour ventiler/refroidir un espace de la grue, un système d'éclairage, une prise électrique.

Selon une possibilité, les équipements d'actionnement comprennent des équipements de montage qui participent au montage de la grue lorsque la grue est dans une configuration de montage, et des équipements de travail qui participent au déplacement d'une charge lorsque la grue est dans une configuration de travail.

La grue peut en outre comprendre une interface utilisateur reliée à l'unité de contrôle - commande pour sélectionner, dans le mode d'alimentation hybride, dans le mode d'alimentation autonome, dans le mode d'alimentation principale et dans le mode mixte recharge/alimentation, un sous-mode de gestion parmi plusieurs sous-modes de gestion selon le procédé de gestion d'alimentation électrique.

Le circuit de conversion peut être un convertisseur électrique AC/AC comprenant un redresseur et un onduleur.

Selon un mode de réalisation, le circuit de conversion comprend au moins un variateur de fréquence.

Le circuit de conversion peut également comprendre un composant électrique destiné à élever la valeur du signal électrique comme un transformateur électrique par exemple.

L'unité de surveillance peut être un microcontrôleur.

Selon un mode de réalisation, l'unité de surveillance sélectionne la source d'alimentation parmi la source d'alimentation primaire et la source d'alimentation secondaire rechargeable grâce à une mise en marche ou une mise à l'arrêt d'interrupteur électrique.

La tension d'alimentation peut avoir une valeur efficace de 230V et la tension d'alimentation triphasée une valeur efficace de 400V par exemple.

Dans une réalisation particulière de la grue, les équipements électriques comprennent des équipements d'actionnement définis en fonction d'une configuration de la grue et des équipements accessoires, et l'unité de contrôle/commande est configurée pour la mise en oeuvre du procédé de répartition décrit ci-dessus, ladite unité de contrôle/commande étant raccordée, d'une part, à une interface permettant une sélection entre le mode brut et le mode optimisé et, d'autre part, à un circuit électrique raccordant la source d'alimentation primaire et la source d'alimentation secondaire rechargeable aux équipements électriques pour contrôler une répartition de la puissance maximale disponible selon le mode sélectionné parmi le mode brut et le mode optimisé.

**[Présentation des Figures]**

L'invention sera mieux comprise à l'aide de la description détaillée qui est exposée ci-dessous en regard des dessins annexés dans lesquels :

[Fig.1] est une représentation schématique d'un mode de gestion d'alimentation électrique pour alimenter électriquement des équipements électriques d'une grue dit mode d'alimentation principale.

[Fig.2] est une représentation schématique d'un deuxième mode de gestion d'alimentation électrique pour alimenter électriquement les équipements électriques de la grue dit mode hybride.

[Fig.3] est une représentation schématique d'un troisième mode de gestion d'alimentation électrique pour alimenter électriquement les équipements électriques de la grue dit mode autonome.

[Fig.4] est une représentation schématique d'un quatrième mode de gestion d'alimentation électrique pour alimenter électriquement les équipements électriques de la grue dit mode mixte recharge/alimentation.

[Fig.5] est une représentation schématique d'un cinquième mode de gestion d'alimentation électrique pour alimenter électriquement les équipements électriques de la grue dit mode de recharge.

[Fig.6] est un organigramme montrant les différentes étapes à exécuter lors de la mise en oeuvre d'un procédé de gestion d'alimentation électrique pour alimenter électriquement les équipements électriques de la grue.

[Fig.7] est un organigramme montrant les différentes étapes à exécuter lors de la mise en oeuvre d'un procédé de répartition d'une puissance électrique pour alimenter électriquement les équipements électriques de la grue.

[Fig.8] est un schéma blocs représentant un circuit de conversion reliant une source d'alimentation primaire et une source d'alimentation secondaire rechargeable aux équipements électrique de la grue.

**[Description détaillée d'un exemple de réalisation de l'invention]**

Dans la description détaillée qui va suivre des figures définies ci-dessus, les mêmes éléments ou les éléments remplissant des fonctions identiques pourront conserver les mêmes références de manière à simplifier la compréhension de l'invention.

La première partie de la description qui suit porte sur la mise en œuvre d'un procédé P de gestion d'alimentation électrique pour alimenter électriquement des équipements électriques 9 d'une grue G, via un circuit de conversion Q, à partir de deux sources d'alimentation :

- une source d'alimentation primaire R comme un réseau électrique et/ou un groupe électrogène par exemple apte à fournir une puissance primaire PR, et
- une source d'alimentation secondaire rechargeable B comme une ou plusieurs batteries rechargeables par exemple apte à fournir une puissance secondaire PB.

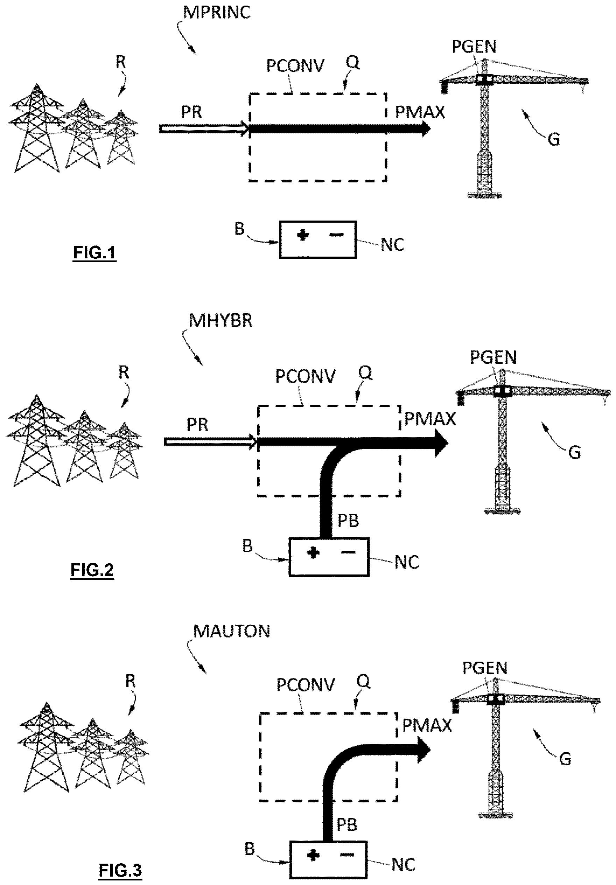

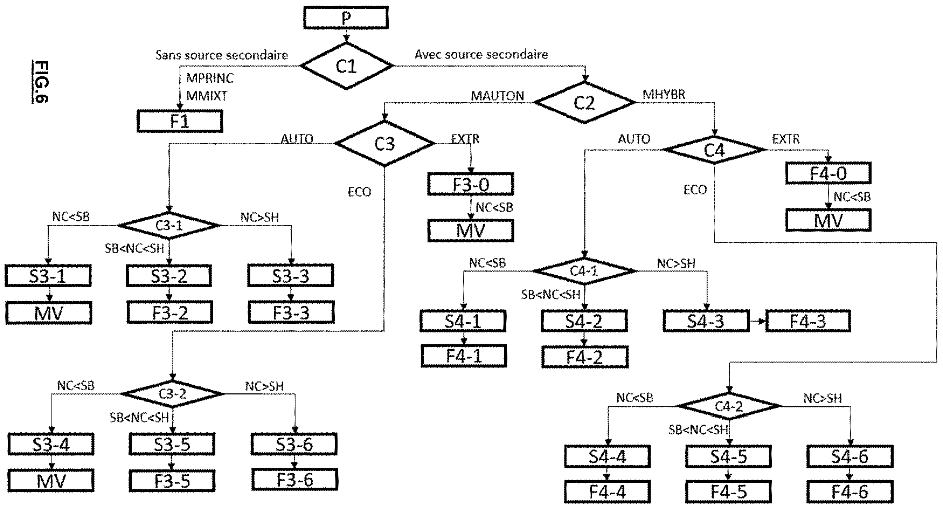

La mise en œuvre des étapes de ce procédé P de gestion d'alimentation électrique est présentée à la figure 6 et ses modes de gestion sont représentés sur les figures 1 à 5.

Ce procédé P de gestion d'alimentation électrique met en œuvre deux étapes de surveillance qui sont :

- une surveillance d'une puissance générale demandée PGEN qui correspond à une puissance demandée par l'ensemble des équipements électriques 9 de la grue G, et
- une surveillance d'un niveau de charge NC de la source d'alimentation secondaire rechargeable B.

De plus, ce procédé P de gestion d'alimentation électrique met en œuvre, en fonction de la puissance générale demandée PGEN et du niveau de charge NC, au moins les modes de gestion suivants :

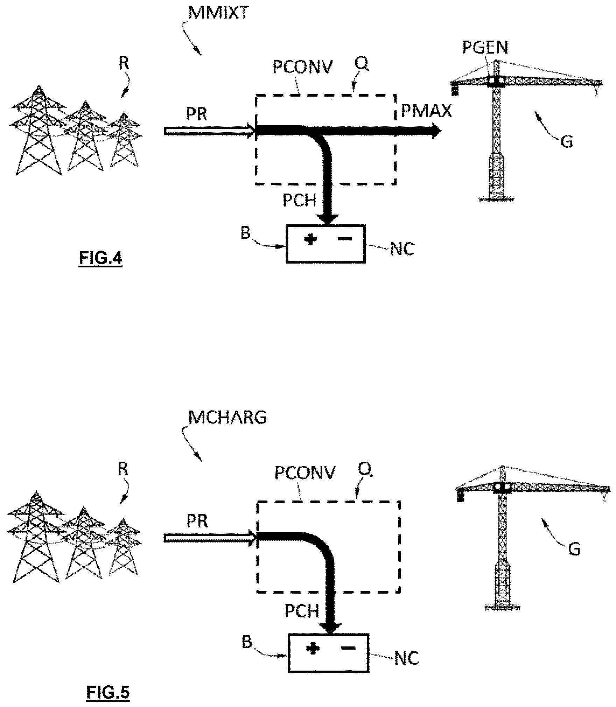

- un mode de recharge MCHARG présenté à la figure 5 dans lequel la puissance générale demandée PGEN est nulle et la source d'alimentation primaire R est disponible et connectée à la source d'alimentation secondaire rechargeable B pour la recharger selon son niveau de charge NC ;
- un mode mixte recharge/alimentation MMIXT présenté à la figure 4 dans lequel la puissance générale demandée PGEN est non nulle, et la source d'alimentation primaire R est disponible et connectée, d'une part, aux équipements électriques 9 de la grue G pour les alimenter électriquement et, d'autre part, à la source d'alimentation secondaire rechargeable B pour la recharger selon le niveau de charge NC ;
- un mode d'alimentation principale MPRINC présenté à la figure 1 dans lequel la puissance générale demandée PGEN est non nulle, et seule la source d'alimentation primaire R est connectée aux équipements électriques 9 de la grue G pour les alimenter électriquement ;
- un mode d'alimentation hybride MHYBR présenté à la figure 2 dans lequel la puissance générale demandée PGEN est non nulle, et la source d'alimentation primaire R et la source d'alimentation secondaire rechargeable B sont toutes deux connectées aux équipements électriques 9 de la grue G pour les alimenter électriquement ; et
- un mode d'alimentation autonome MAUTON présenté à la figure 3 dans lequel la puissance générale demandée PGEN est non nulle, et seule la source d'alimentation secondaire rechargeable B est connectée aux équipements électriques 9 de la grue G pour les alimenter électriquement selon le niveau de charge NC.

Dans le procédé P de gestion d'alimentation électrique, les équipements électriques 9 sont alimentés par une puissance maximale disponible PMAX qui correspond au minimum entre une puissance de conversion maximale PCONV et une puissance source PS, où la puissance de conversion maximale PCONV correspond à une puissance maximale pouvant être délivrée en sortie du circuit de conversion Q.

La puissance source PS dépend quant à elle du mode de gestion, et elle correspond à :

- la somme de la puissance secondaire PB et de la puissance primaire PR dans le mode d'alimentation hybride MHYBR de la Figure 2 ;
- la puissance secondaire PB dans le mode d'alimentation autonome MAUTON de la Figure 3 ;
- la puissance primaire PR dans le mode d'alimentation principale MPRINC de la Figure 1 ; et
- la puissance primaire PR moins une puissance de recharge PCH servant à recharger la source d'alimentation secondaire rechargeable B dans le mode mixte recharge/alimentation MMIXT de la Figure 4.

Par ailleurs, le procédé P de gestion d'alimentation électrique met en œuvre, dans le mode d'alimentation autonome MAUTON et dans le mode d'alimentation hybride MHYBR, une adaptation de la puissance secondaire PB en fonction au moins du niveau de charge NC, ladite puissance secondaire PB étant inférieure ou égale à une puissance maximale secondaire PBMAX qui correspond à une puissance maximale pouvant être délivrée par la source d'alimentation secondaire rechargeable B.

Ainsi, et en référence à la figure 6, le procédé P de gestion d'alimentation électrique commence par une étape de sélection d'alimentation C1, ou étape « SELECTION ALIMENTATION », au cours de laquelle est exécutée une sélection ou une désélection de la source secondaire rechargeable B pour alimenter les équipements électriques 9 de la grue G. Autrement dit, cette étape de sélection d'alimentation C1 opère une sélection de l'alimentation avec ou sans la source secondaire rechargeable B. Ainsi, à l'issue de l'étape de sélection d'alimentation C1, la source secondaire rechargeable B est :

- soit connectée aux équipements électriques 9 de la grue G pour participer à leur alimentation électrique, ce qui amène au mode d'alimentation hybride MHYBR ou au mode d'alimentation autonome MAUTON ;
- soit déconnectée des équipements électriques 9 de la grue G pour ne pas participer à leur alimentation électrique, ce qui amène au mode d'alimentation principale MPRINC ou au mode mixte recharge/alimentation MMIXT.

Si, à l'issue de l'étape de sélection d'alimentation C1, la source secondaire rechargeable B est déconnectée, alors c'est le mode d'alimentation principale MPRINC ou le mode mixte recharge/alimentation MMIXT qui est sélectionné, et s'ensuit l'exécution d'une étape F1, ou étape « REPARTITION PUISSANCE », pour initier un procédé de répartition de la puissance maximale disponible PMAX. Pour rappel, la puissance maximale disponible PMAX correspond :

- dans le mode d'alimentation principale MPRINC, au minimum entre la puissance de conversion maximale PCONV et la puissance primaire PR ; et
- dans le mode mixte recharge/alimentation MMIXT, au minium entre la puissance de conversion maximale PCONV et la puissance primaire PR moins la puissance de recharge PCH.

Si par contre, à l'issue de l'étape de sélection d'alimentation C1, la source secondaire rechargeable B est connectée (c'est-à-dire que l'alimentation électrique fera appel à la source secondaire rechargeable B), alors s'ensuit l'exécution d'une étape de sélection de mode C2, ou étape « SELECTION MODE », qui consiste à sélectionner entre le mode d'alimentation hybride MHYBR et le mode d'alimentation autonome MAUTON.

Cette étape de sélection d'alimentation C1 suivie de cette étape de sélection de mode C2 amène ainsi à sélectionner le mode de gestion. En fonction de différents paramètres, et en particulier de la puissance générale demandée PGEN, de la disponibilité de la source d'alimentation primaire R et de la puissance primaire PR, ces étapes de sélection C1, C2 peuvent s'opérer de manière automatique pour la sélection du mode de gestion.

Ainsi, lorsque la puissance générale demandée PGEN est non nulle, les modes de gestion suivants peuvent être automatiquement mis en œuvre ou sélectionnés (lors des deux étapes de sélection C1, C2 successives) :

- le mode d'alimentation autonome MAUTON est automatiquement mis en œuvre (ou sélectionné) si la source d'alimentation primaire R n'est pas disponible ;
- le mode d'alimentation principale MPRINC ou le mode mixte recharge/alimentation MMIXT est automatiquement mis en œuvre (ou sélectionné) en fonction du niveau de charge NC de la source d'alimentation secondaire rechargeable B, si la source d'alimentation primaire R est disponible et si la puissance générale demandée PGEN est inférieure à la puissance primaire PR ;
- le mode d'alimentation hybride MHYBR est automatiquement mis en œuvre (ou sélectionné) si la source d'alimentation primaire R est disponible et si la puissance générale demandée PGEN est supérieure à la puissance primaire PR.

Après l'étape de sélection de mode C2, le procédé P de gestion d'alimentation électrique met en œuvre une sélection, dans le mode d'alimentation hybride MHYBR et dans le mode d'alimentation autonome MAUTON, d'un sous-mode de gestion parmi plusieurs sous-modes de gestion comprenant au moins :

- un sous-mode automatique « AUTO » dans lequel la puissance secondaire PB est contrôlée pour correspondre à ka fois la puissance maximale secondaire PBMAX, où ka est un coefficient qui est inférieur ou égal à 1 et qui diminue avec le niveau de charge NC jusqu'à ce que le niveau de charge NC passe en-dessous d'un seuil bas SB ;
- un sous-mode économique « ECO » dans lequel la puissance secondaire PB est contrôlée pour correspondre à ke fois la puissance maximale secondaire PBMAX, où ke est un coefficient inférieur à ka et qui diminue avec le niveau de charge NC jusqu'à ce que le niveau de charge NC passe en-dessous d'un seuil bas SB ;
- un sous-mode extrême « EXTR » dans lequel la puissance secondaire PB correspond à la puissance maximale secondaire PBMAX quel que soit la valeur du niveau de charge NC de la source d'alimentation secondaire rechargeable B.

Le seuil bas SB peut être compris entre 5 et 15 % d'une capacité de charge de la source d'alimentation secondaire rechargeable B et un seuil haut SH peut être compris entre 40 et 60 % d'une capacité de charge de la source d'alimentation secondaire rechargeable B.

En référence à la figure 6, si le mode d'alimentation sélectionné lors de l'étape de sélection de mode C2 est le mode d'alimentation autonome MAUTON, alors est exécutée une étape de sélection de sous-mode C3, ou étape « SELECTION SOUS-MODE », dans laquelle s'opère une sélection entre le sous-mode automatique « AUTO », le sous-mode économique « ECO » et le sous-mode extrême « EXTR ».

Si le sous-mode sélectionné lors de l'étape de sélection de sous-mode C3 est le sous-mode automatique « AUTO », alors est exécutée une étape de contrôle du niveau de charge C3-1, ou étape « CONTROLE NIVEAU DE CHARGE », au cours de laquelle le niveau de charge NC de la source d'alimentation secondaire rechargeable B est mesuré et est comparé avec le seuil bas SB et le seuil haut SH.

Si, lors de l'étape de contrôle du niveau de charge C3-1, le niveau de charge NC de la source d'alimentation secondaire rechargeable B est inférieur au seuil bas SB, alors est exécutée une étape S3-1, ou étape « KA=0 », qui fixe le coefficient ka à zéro, de sorte que la puissance secondaire PB est nulle. Autrement dit, si le niveau de charge NC est inférieur à 5 à 15 % de la capacité de charge, alors la source d'alimentation secondaire rechargeable B fournie aucune puissance. A l'issue de cette étape S3-1, le procédé P bascule automatiquement dans un mode de veille désigné par « MV » à la figure 6.

Si, lors de l'étape de contrôle du niveau de charge C3-1, le niveau de charge NC de la source d'alimentation secondaire rechargeable B est compris entre le seuil bas SB et le seuil haut SH, alors est exécutée une étape S3-2, ou étape « KA=KAMIN », qui fixe le coefficient ka à une valeur kamin, kamin étant compris entre 0,5 et 0,7. Autrement dit, et par exemple, si le niveau de charge NC de la batterie est de 30% de sa capacité de charge, alors la puissance secondaire PB fournie est égale à kamin fois la puissance maximale secondaire PBMAX, soit PB=kamin.PBMAX. Cette étape S3-2 est suivie d'une étape F3-2, ou étape « REPARTITION PUISSANCE », qui met en œuvre un procédé de répartition de la puissance maximale disponible PMAX, où la puissance maximale disponible PMAX correspond au minimum entre la puissance de conversion maximale PCONV et la puissance source PS qui équivaut à la puissance secondaire PB qui est égal à kamin.PBMAX dans ce sous-mode automatique « AUTO » du mode d'alimentation autonome MAUTON. Ces étapes S3-2 et F3-2 sont exécutées tant que le niveau de charge NC est compris entre le seuil bas SB et le seuil haut SH et, si le niveau de charge NC passe en-dessous du seuil bas SB, alors est exécutée l'étape S3-1.

Si lors de l'étape de contrôle du niveau de charge C3-1, le niveau de charge NC de la source d'alimentation secondaire rechargeable B est supérieur au seuil haut SH, alors est exécutée une étape S3-3, ou étape « KA=KAMAX », qui fixe le coefficient ka à une valeur kamax, kamax étant supérieur à kamin et par exemple compris entre 0,8 et 1. Autrement dit, et par exemple, si le niveau de charge NC de la batterie est de 90% de sa capacité de charge, alors la puissance secondaire PB fournie est égale à kamax fois la puissance maximale secondaire PBMAX, soit PB=kamax.PBMAX. Cette étape S3-3 est suivie d'une étape F3-3, ou étape « REPARTITION PUISSANCE », qui met en œuvre un procédé de répartition de la puissance maximale disponible PMAX, où la puissance maximale disponible PMAX correspond au minimum entre la puissance de conversion maximale PCONV et la puissance source PS qui équivaut à la puissance secondaire PB qui est égal à kamax.PBMAX dans ce sous-mode automatique « AUTO » du mode d'alimentation autonome MAUTON. Ces étapes S3-3 et F3-3 sont exécutées tant que le niveau de charge NC est supérieur au seuil haut SH et, si le niveau de charge NC passe en-dessous du seuil haut SH, alors sont exécutées les étapes S3-2 et F3-2.

Si le sous-mode sélectionné lors de l'étape de sélection de sous-mode C3 est le sous-mode économique « ECO », alors est exécutée une étape de contrôle du niveau de charge C3-2, ou étape « CONTROLE NIVEAU DE CHARGE », au cours de laquelle le niveau de charge NC de la source d'alimentation secondaire rechargeable B est mesuré et est comparé avec le seuil bas SB et le seuil haut SH.

Si lors de l'étape de contrôle du niveau de charge C3-2, le niveau de charge NC de la source d'alimentation secondaire rechargeable B est inférieur au seuil bas SB, alors est exécutée une étape S3-4, ou étape « KE=0 », qui fixe le coefficient ke à zéro, de sorte que la puissance secondaire PB est nulle. Autrement dit, si le niveau de charge NC est inférieur à 5 à 15 % de la capacité de charge, alors la source d'alimentation secondaire rechargeable B fournie aucune puissance. A l'issue de cette étape S3-4, le procédé P bascule automatiquement dans un mode de veille désigné par « MV » à la figure 6.

Ainsi, dans le mode d'alimentation autonome MAUTON, et que ce soit dans le sous-mode automatique « AUTO » ou dans le sous-mode économique « ECO », le procédé P de gestion d'alimentation électrique passe automatiquement dans le mode de veille « MV » après que le niveau de charge NC de la source d'alimentation secondaire rechargeable B soit passé en-dessous du seuil bas SB, où dans ce mode de veille « MV » sont alimentés uniquement des équipements de sécurité prédéfinis parmi les équipements électriques 9 de la grue G pour permettre une mise en sécurité de la grue G. Dans le mode de veille MV, la puissance secondaire PB peut être contrôlée pour correspondre à la puissance maximale secondaire PBMAX afin d'alimenter ces équipements de sécurité au moins le temps de la mise en sécurité de la grue G.

Ces équipements de sécurité peuvent comprendre des équipements qui vont par exemple permettre de lever la flèche 7 avant de libérer celle-ci en orientation afin qu'elle soit libre de tourner avec le vent tout en offrant un rayon de giration réduit, la flèche 7 est alors décrite comme étant mise en girouette.

Si lors de l'étape de contrôle du niveau de charge C3-2, le niveau de charge NC de la source d'alimentation secondaire rechargeable B est compris entre le seuil bas SB et le seuil haut SH, alors est exécutée une étape S3-5, ou étape « KE=KEMIN », qui fixe le coefficient ke à une valeur kemin, kemin étant compris entre 0,2 et 0,4. Autrement dit, et par exemple, si le niveau de charge NC de la batterie est de 30% de sa capacité de charge, alors la puissance secondaire PB fournie est égale à kemin fois la puissance maximale secondaire PBMAX, soit PB=kemin.PBMAX. Cette étape S3-5 est suivie d'une étape F3-5, ou étape « REPARTITION PUISSANCE », qui met en œuvre un procédé de répartition de la puissance maximale disponible PMAX, où la puissance maximale disponible PMAX correspond au minimum entre la puissance de conversion maximale PCONV et la puissance source qui équivaut à la puissance secondaire PB qui est égal à kemin.PBMAX dans ce sous-mode économique « ECO » du mode d'alimentation autonome MAUTON. Ces étapes S3-5 et F3-5 sont exécutées tant que le niveau de charge NC est compris entre le seuil bas SB et le seuil haut SH et, si le niveau de charge NC passe en-dessous du seuil bas SB, alors est exécutée l'étape S3-4.

Si lors de l'étape de contrôle du niveau de charge C3-2, le niveau de charge NC de la source d'alimentation secondaire rechargeable B est supérieur au seuil haut SH, alors est exécutée une étape S3-6, ou étape « KE=KEMAX », qui fixe le coefficient ke à une valeur kemax, kemax étant supérieur à kemin et kemax étant par exemple compris entre 0,6 et 0,8. Autrement dit, et par exemple, si le niveau de charge NC de la batterie est de 90% de sa capacité, alors la puissance secondaire PB est égale à kemax fois la puissance maximale secondaire PBMAX, soit PB=kemax.PBMAX. Cette étape S3-6 est suivie d'une étape F3-6, ou étape « REPARTITION PUISSANCE », qui met en œuvre un procédé de répartition de la puissance maximale disponible PMAX, où la puissance maximale disponible PMAX correspond au minimum entre la puissance de conversion maximale PCONV et la puissance source qui équivaut à la puissance secondaire PB qui est égal à kemax.PBMAX dans ce sous-mode économique « ECO » du mode d'alimentation autonome MAUTON. Ces étapes S3-6 et F3-6 sont exécutées tant que le niveau de charge NC est supérieur au seuil haut SH et, si le niveau de charge NC passe en-dessous du seuil haut SH, alors sont exécutées les étapes S3-5 et F3-5.

En principe, la valeur de kemax est supérieure à celle de kemin, et kamax est supérieur à kemax et kamin est supérieur kemin.

Si le sous-mode sélectionné lors de l'étape de sélection de sous-mode C3 est le sous-mode extrême « EXTR », alors est exécutée une étape F3-0, ou étape « REPARTITION PUISSANCE », qui met en œuvre un procédé de répartition de la puissance maximale disponible PMAX, où la puissance maximale disponible PMAX correspond au minimum entre la puissance de conversion maximale PCONV et la puissance source qui équivaut à la puissance secondaire PB qui est égal à PBMAX dans ce sous-mode extrême « EXTR » du mode d'alimentation autonome MAUTON.

Selon une possibilité, dans le sous-mode extrême « EXTR » dans l'étape F3-0, lorsque le niveau de charge NC de la source d'alimentation secondaire rechargeable B est passé en-dessous du seuil bas SB alors le procédé P bascule automatiquement dans le mode de veille « MV » précédemment décrit, au cours duquel sont alimentés uniquement des équipements de sécurité de la grue G pour permettre une mise en sécurité de la grue G.

En référence à la figure 6, si le mode d'alimentation sélectionné lors de l'étape de sélection de mode C2 est le mode d'alimentation hybride MHYBR, alors est exécutée une étape de sélection de sous-mode C4 dans laquelle s'opère une sélection entre le sous-mode automatique « AUTO », le sous-mode économique « ECO » et le sous-mode extrême « EXTR ».

Si le sous-mode sélectionné lors de l'étape de sélection de sous-mode C4 est le sous-mode automatique « AUTO », alors est exécutée une étape de contrôle du niveau de charge C4-1, ou étape « CONTROLE NIVEAU DE CHARGE », au cours de laquelle le niveau de charge NC de la source d'alimentation secondaire rechargeable B est mesuré et est comparé avec le seuil bas SB et le seuil haut SH.

Si, lors de l'étape de contrôle du niveau de charge C4-1, le niveau de charge NC de la source d'alimentation secondaire rechargeable B est inférieur au seuil bas SB, alors est exécutée une étape S4-1, ou étape « KA=0 », qui fixe le coefficient ka à zéro, de sorte que la puissance secondaire PB est nulle. Autrement dit, si le niveau de charge NC est inférieur à 5 à 15 % de la capacité de charge, alors la source d'alimentation secondaire rechargeable B ne fournit aucune puissance, et ainsi la puissance source PS est intégralement fournie par la source d'alimentation primaire R. Cette étape S4-1 est suivie d'une étape F4-1, ou étape « REPARTITION PUISSANCE », qui met en œuvre un procédé de répartition de la puissance maximale disponible PMAX, où la puissance maximale disponible PMAX correspond au minimum entre la puissance de conversion maximale PCONV et la puissance source PS qui équivaut à la puissance primaire PR, soit PS=PR, dans ce sous-mode automatique « AUTO » du mode d'alimentation hybride MHYBR.

Si lors de l'étape de contrôle du niveau de charge C4-1, le niveau de charge NC de la source d'alimentation secondaire rechargeable B est compris entre le seuil bas SB et le seuil haut SH, alors est exécutée une étape S4-2, ou étape « KA=KAMIN », qui fixe le coefficient ka à la valeur kamin, kamin étant compris entre 0,5 et 0,7. Autrement dit, et par exemple, si le niveau de charge NC de la batterie est de 30% de sa capacité de charge, alors la puissance secondaire PB fournie est égale à kamin fois la puissance maximale secondaire PBMAX, soit PB=kamin.PBMAX. Cette étape S4-2 est suivie d'une étape F4-2, ou étape « REPARTITION PUISSANCE », qui met en œuvre un procédé de répartition de la puissance maximale disponible PMAX, où la puissance maximale disponible PMAX correspond au minimum entre la puissance de conversion maximale PCONV et la puissance source PS qui équivaut à la somme de la puissance primaire PR et de la puissance secondaire PB, soit PS=PR+kamin.PBMAX dans ce sous-mode automatique « AUTO » du mode d'alimentation hybride MHYBR. Ces étapes S4-2 et F4-2 sont exécutées tant que le niveau de charge NC est supérieur au seuil bas SB et, si le niveau de charge NC passe en-dessous du seuil bas SB, alors sont exécutées les étapes S4-1 et F4-1.

Si lors de l'étape de contrôle du niveau de charge C4-1, le niveau de charge NC de la source d'alimentation secondaire rechargeable B est supérieur au seuil haut SH, alors est exécutée une étape S4-3, ou étape « KA=KAMAX », qui fixe le coefficient ka à la valeur kamax, kamax étant compris entre 0,8 et 1. Autrement dit, et par exemple, si le niveau de charge NC de la batterie est de 90% de sa capacité de charge, alors la puissance secondaire PB fournie est égale à kamax fois la puissance maximale secondaire PBMAX, soit PB=kamax.PBMAX. Cette étape S4-3 est suivie d'une étape F4-3, ou étape « REPARTITION PUISSANCE », qui met en oeuvre un procédé de répartition de la puissance maximale disponible PMAX, où la puissance maximale disponible PMAX correspond au minimum entre la puissance de conversion maximale PCONV et la puissance source PS qui équivaut à la somme de la puissance primaire PR et de la puissance secondaire PB, soit PS=PR+kamax.PBMAX dans ce sous-mode automatique « AUTO » du mode d'alimentation hybride MHYBR. Ces étapes S4-3 et F4-3 sont exécutées tant que le niveau de charge NC est supérieur au seuil haut SH et, si le niveau de charge NC passe en-dessous du seuil haut SH, alors sont exécutées les étapes S4-2 et F4-2.

Si le sous-mode sélectionné lors de l'étape de sélection de sous-mode C4 est le sous-mode économique « ECO », alors est exécutée une étape de contrôle du niveau de charge C4-2, ou étape « CONTROLE NIVEAU DE CHARGE », au cours de laquelle le niveau de charge NC de la source d'alimentation secondaire rechargeable B est mesuré et est comparé avec le seuil bas SB et le seuil haut SH.

Si, lors de l'étape de contrôle du niveau de charge C4-2, le niveau de charge NC de la source d'alimentation secondaire rechargeable B est inférieur au seuil bas SB, alors est exécutée une étape S4-4, ou étape « KE=0 », qui fixe le coefficient ke à zéro, de sorte que la puissance secondaire PB est nulle. Autrement dit, si le niveau de charge NC est inférieur à 5 à 15 % de la capacité de charge, alors la source d'alimentation secondaire rechargeable B ne fournit aucune puissance, et ainsi la puissance source PS est intégralement fournie par la source d'alimentation primaire R. Cette étape S4-4 est suivie d'une étape F4-4, ou étape « REPARTITION PUISSANCE », qui met en œuvre un procédé de répartition de la puissance maximale disponible PMAX, où la puissance maximale disponible PMAX correspond au minimum entre la puissance de conversion maximale PCONV et la puissance source PS qui équivaut à la puissance primaire PR, soit PS=PR, dans ce sous-mode économique « ECO » du mode d'alimentation hybride MHYBR.

Si lors de l'étape de contrôle du niveau de charge C4-2, le niveau de charge NC de la source d'alimentation secondaire rechargeable B est compris entre le seuil bas SB et le seuil haut SH, alors est exécutée une étape S4-5, ou étape « KE=KEMIN », qui fixe le coefficient ke à la valeur kemin, kemin étant compris entre 0,2 et 0,4. Autrement dit, et par exemple, si le niveau de charge NC de la batterie est de 30% de sa capacité de charge, alors la puissance secondaire PB fournie est égale à kemin fois la puissance maximale secondaire PBMAX, soit PB=kemin.PBMAX. Cette étape S4-5 est suivie d'une étape F4-5, ou étape « REPARTITION PUISSANCE », qui met en œuvre un procédé de répartition de la puissance maximale disponible PMAX, où la puissance maximale disponible PMAX correspond au minimum entre la puissance de conversion maximale PCONV et la puissance source PS qui équivaut à la somme de la puissance primaire PR et de la puissance secondaire PB, soit PS=PR+kemin.PBMAX dans ce sous-mode économique « ECO » du mode d'alimentation hybride MHYBR. Ces étapes S4-5 et F4-5 sont exécutées tant que le niveau de charge NC est supérieur au seuil bas SB et, si le niveau de charge NC passe en-dessous du seuil bas SB, alors sont exécutées les étapes S4-4 et F4-4.

Si lors de l'étape de contrôle du niveau de charge C4-2, le niveau de charge NC de la source d'alimentation secondaire rechargeable B est supérieur au seuil haut SH, alors est exécutée une étape S4-6, ou étape « KE=KEMAX », qui fixe le coefficient ke à la valeur kemax, kemax étant compris entre 0,6 et 0,8. Autrement dit, et par exemple, si le niveau de charge NC de la batterie est de 90% de sa capacité de charge, alors la puissance secondaire PB fournie est égale à kemax fois la puissance maximale secondaire PBMAX, soit PB=kemax.PBMAX. Cette étape S4-6 est suivie d'une étape F4-6, ou étape « REPARTITION PUISSANCE », qui met en œuvre un procédé de répartition de la puissance maximale disponible PMAX, où la puissance maximale disponible PMAX correspond au minimum entre la puissance de conversion maximale PCONV et la puissance source PS qui équivaut à la somme de la puissance primaire PR et de la puissance secondaire PB, soit PS=PR+kemax.PBMAX dans ce sous-mode économique « ECO » du mode d'alimentation hybride MHYBR. Ces étapes S4-6 et F4-6 sont exécutées tant que le niveau de charge NC est supérieur au seuil haut SH et, si le niveau de charge NC passe en-dessous du seuil haut SH, alors sont exécutées les étapes S4-5 et F4-5.

Si le sous-mode sélectionné lors de l'étape de sélection de sous-mode C4 est le sous-mode extrême « EXTR », alors est exécutée une étape F4-0, ou étape « REPARTITION PUISSANCE », qui met en œuvre un procédé de répartition de la puissance maximale disponible PMAX, où la puissance maximale disponible PMAX correspond au minimum entre la puissance de conversion maximale PCONV et la puissance source PS qui équivaut à la somme de la puissance primaire PR et de la puissance secondaire PB qui est égal à PBMAX, soit PS=PR+PBMAX dans ce sous-mode extrême « EXTR » du mode d'alimentation hybride MHYBR.

Selon une possibilité, dans le sous-mode extrême « EXTR » dans l'étape F4-0, lorsque le niveau de charge NC de la source d'alimentation secondaire rechargeable B est passé en-dessous du seuil bas SB alors le procédé P bascule automatiquement dans le mode de veille « MV » précédemment décrit, au cours duquel sont alimentés uniquement des équipements de sécurité de la grue G pour permettre une mise en sécurité de la grue G.

La seconde partie de la description qui suit porte sur la mise en œuvre du procédé de répartition F pour répartir la puissance maximale disponible PMAX sur les différents équipements électriques 9 de la grue G, quel que soit le mode de gestion parmi le mode d'alimentation hybride MHYBR, le mode d'alimentation autonome MAUTON, le mode d'alimentation principale MPRINC et le mode mixte recharge/alimentation MMIXT. L'objet de ce procédé de répartition F est d'optimiser la distribution de la puissance maximale disponible PMAX, en particulier lorsque cette puissance maximale disponible PMAX est insuffisante pour alimenter en pleine capacité l'ensemble des équipements électriques 9 de la grue G

Comme précédemment décrit, la puissance maximale disponible PMAX dépend du mode de gestion, du sous-mode de gestion et du niveau de charge NC de la source d'alimentation secondaire rechargeable B, avec une puissance maximale disponible PMAX qui est équivalente au minimum entre la puissance de conversion maximale PCONV et la puissance source PS qui équivaut à :

- dans l'étape F1 en mode d'alimentation principale MPRINC, la puissance primaire PR (soit PS=PR) ;
- dans l'étape F1 en mode mixte recharge/alimentation MMIXT, la puissance primaire PR moins la puissance de recharge PCH (soit PS=PR-PCH) ;
- dans l'étape F3-2 en sous-mode automatique « AUTO » du mode d'alimentation autonome MAUTON, la puissance secondaire PB qui est égal à kamin.PBMAX (soit PS=PB=kamin.PBMAX) ;
- dans l'étape F3-3 en sous-mode automatique « AUTO » du mode d'alimentation autonome MAUTON, la puissance secondaire PB qui est égal à kamax.PBMAX (soit PS=PB=kamax.PBMAX) ;
- dans l'étape F3-5 en sous-mode économique « ECO » du mode d'alimentation autonome MAUTON, la puissance secondaire PB qui est égal à kemin.PBMAX (soit PS=PB=kemin.PBMAX) ;
- dans l'étape F3-6 en sous-mode économique « ECO » du mode d'alimentation autonome MAUTON, la puissance secondaire PB qui est égal à kemax.PBMAX (soit PS=PB=kemax.PBMAX) ;
- dans l'étape F3-0 en sous-mode extrême « EXTR » du mode d'alimentation autonome MAUTON, la puissance secondaire PB qui est égal à PBMAX (soit PS=PB=PBMAX) ;
- dans l'étape F4-1 en sous-mode automatique « AUTO » du mode d'alimentation hybride MHYBR, la puissance primaire PR (soit PS=PR) ;
- dans l'étape F4-2 en sous-mode automatique « AUTO » du mode d'alimentation hybride MHYBR, la somme de la puissance primaire PR et de la puissance secondaire PB qui est égal à kamin.PBMAX (soit PS=PR+PB=PR+kamin.PBMAX) ;
- dans l'étape F4-3 en sous-mode automatique « AUTO » du mode d'alimentation hybride MHYBR, la somme de la puissance primaire PR et de la puissance secondaire PB qui est égal à kamax.PBMAX (soit PS=PR+PB=PR+kamax.PBMAX) ;
- dans l'étape F4-4 en sous-mode économique « ECO » du mode d'alimentation hybride MHYBR, la puissance primaire PR (soit PS=PR) ;
- dans l'étape F4-5 en sous-mode économique « ECO » du mode d'alimentation hybride MHYBR, la somme de la puissance primaire PR et de la puissance secondaire PB qui est égal à kemin.PBMAX (soit PS=PR+PB=PR+kemin.PBMAX) ;
- dans l'étape F4-6 en sous-mode économique « ECO » du mode d'alimentation hybride MHYBR, la somme de la puissance primaire PR et de la puissance secondaire PB qui est égal à kemax.PBMAX (soit PS=PR+PB=PR+kemax.PBMAX) ;
- dans l'étape F4-0 en sous-mode extrême « EXTR » du mode d'alimentation hybride MHYBR, la somme de la puissance primaire PR et de la puissance secondaire PB qui est égal à PBMAX (soit PS=PR+PB=PR+PBMAX).

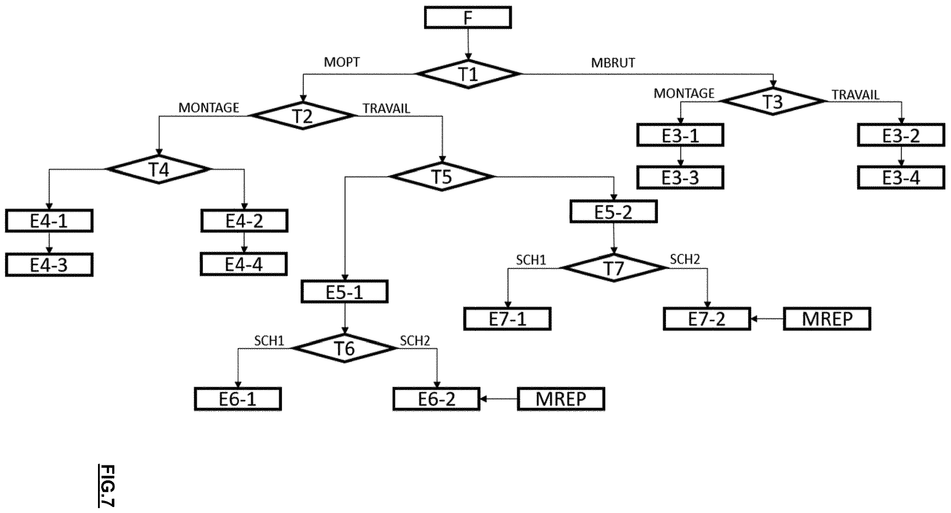

En référence à la Figure 7, ce procédé de répartition F met en œuvre une étape initiale de sélection T1, ou étape « SELECTION MODE », qui consiste en une sélection entre :

- un mode brut « MBRUT » dans lequel la puissance maximale disponible PMAX est répartie sur des équipements d'actionnement 91, 92 prédéfinis et sur des équipements accessoires 93, 94 prédéfinis parmi les équipements électriques 9 de la grue G, les équipements d'actionnement 91, 92 étant définis en fonction d'une configuration de la grue G; et
- un mode optimisé « MOPT » dans lequel la puissance maximale disponible PMAX est répartie sur les équipements d'actionnement 91, 92 prédéfinis, et aussi sur des équipements accessoires 93, 94 mais en fonction également de conditions de coupure associées aux équipements accessoires 93, 94, de sorte que selon leurs conditions de coupure respectives les équipements accessoires 93, 94 sont alimentés ou non.

Les équipements d'actionnement 91, 92 peuvent comprendre des équipements de montage 91 qui participent au montage de la grue G lorsque la grue G est dans une configuration de montage désignée par « MONTAGE » sur la figure 7, et les équipements d'actionnement 91, 92 comprennent des équipements de travail 92 qui participent au déplacement d'une charge lorsque la grue G est dans une configuration de travail désignée par « TRAVAIL » sur la figure 7. Il est envisageable que la grue G ne comprenne pas d'équipement de montage 91, comme par exemple dans le cas d'une grue à montage par éléments.

Les équipements de montage 91 peuvent comprendre l'un au moins des équipements suivants : une centrale hydraulique de pliage/dépliage permettant un pliage/dépliage d'un mât et d'une flèche, une centrale hydraulique de calage permettant un calage de la grue au sol, une centrale hydraulique d'orientation permettant une orientation d'une base de la grue, une centrale hydraulique de potence permettant un actionnement d'une potence de montage. De manière générale, en configuration de montage, autrement dit lors des phases de montage/démontage de la grue, soit un seul équipement de montage est actionné (par exemple la centrale hydraulique de pliage/dépliage), soit plusieurs équipements de montage 91 sont actionnés successivement et individuellement car les phases de montage/démontage sont séquencées.

Les équipements de travail 92 peuvent comprendre l'un au moins des équipements suivants : un système motorisé de levage 920 permettant un levage/abaissement d'une charge, un système motorisé de distribution 921 permettant une distribution d'une charge le long d'une flèche 7, un système motorisé d'orientation 922 permettant une orientation d'une flèche 7, un système motorisé de translation permettant une translation de la grue, un système motorisé de relevage permettant un relevage d'une flèche relevable (ou flèche inclinable). De manière générale, en configuration de travail, autrement dit lors des phases de déplacement d'une charge, plusieurs équipements de travail 92 sont actionnés simultanément, et parfois sont actionnés successivement et individuellement.

Pour la suite de la description, trois équipements de travail 92 seront considérés pour la grue G lorsqu'en configuration de travail, à savoir :

- le système motorisé de levage 920 qui reçoit une puissance électrique de levage PLEV, qui est inférieure ou égale à la puissance électrique demandée par ce système motorisé de levage 920 ;
- le système motorisé de distribution 921 qui reçoit une puissance électrique de distribution PDIST, qui est inférieure ou égale à la puissance électrique demandée par ce système motorisé de distribution 921 ;
- le système motorisé d'orientation 922 qui reçoit une puissance électrique d'orientation PORIEN, qui est inférieure ou égale à la puissance électrique demandée par ce système motorisé d'orientation 922.

Les équipements accessoires 93, 94 sont des équipements qui ne participent pas aux opérations de montage et de déplacement d'une charge ou d'un élément structurel de la grue G, et ces équipements accessoires 93, 94 peuvent comprendre un ou plusieurs équipements accessoires de système 93 et/ou un ou plusieurs équipements accessoires d'utilisateur 94.

Les équipements accessoires de système 93 peuvent comprendre l'un au moins des équipements suivants :

- un système de chauffage 931 pour chauffer un espace 71 de la grue, comme par exemple une cabine de pilotage,
- un système de ventilation ou de refroidissement 932 pour ventiler/refroidir un espace 72 de la grue ;

et les conditions de coupure pour ces équipements accessoires de système 931, 932, dans le mode optimisé « MOPT », peuvent dépendre d'au moins un paramètre environnemental qui est un paramètre physique représentatif de l'espace 71, 72 de la grue G. Selon une possibilité, ce paramètre environnemental est une température intérieure de l'espace 71, 72 de la grue G.

L'espace 72 de la grue G peut correspondre à une armoire électrique regroupant intérieurement tout ou partie des organes participant à l'alimentation électrique de la grue G. Autrement dit, dans le mode optimisé « MOPT », le chauffage de la cabine de pilotage 71, et la ventilation ou le refroidissement de cette armoire électrique 72 dépendra de conditions de coupure qui sont fonction de la température intérieure respectivement dans cette cabine de pilotage 71 et dans cette armoire électrique 72.

Les équipements accessoires d'utilisateur 94 peuvent comprendre l'un au moins des équipements suivants : un système d'éclairage 941, une prise électrique 942 ; et les conditions de coupure de ces équipements accessoires d'utilisateur 94, dans le mode optimisé « MOPT », peuvent dépendre d'une sélection d'une classification opérée par un utilisateur pour le ou chacun des équipements accessoires d'utilisateur 94, parmi les classifications suivantes :

- une classification « non essentielle » qui correspond à une autorisation de ne pas alimenter l'équipement accessoire utilisateur 94 correspondant en mode optimisé MOPT au profit des équipements d'actionnement 91, 92 ; et
- une classification « essentielle » qui correspond à une interdiction de ne pas alimenter l'équipement accessoire utilisateur 94 correspondant en mode optimisé MOPT.

En référence à la Figure 7, si lors de l'étape initiale de sélection T1, le mode brut MBRUT est sélectionné, alors est exécutée une étape de sélection de configuration T3, ou étape « SELECTION CONFIGURATION », dans laquelle se fait un choix de configuration de la grue entre la configuration de montage et la configuration de travail.

Et de la même manière, si lors de l'étape initiale de sélection T1, le mode optimisé MOPT est sélectionné, alors est exécutée une étape de sélection de configuration T2, ou étape « SELECTION CONFIGURATION », dans laquelle se fait un choix de configuration de la grue entre la configuration de montage et la configuration de travail.

Si, dans le mode brut MBRUT, lors de l'étape de sélection de configuration T3, la configuration de montage est sélectionnée alors est exécutée une étape E3-1, ou étape « DISTRIBUTION PMAX », au cours de laquelle la puissance maximale disponible PMAX est répartie sur les équipements d'actionnement 91, 92 (qui sont ici les équipements de montage 91) et sur les équipements accessoires 93, 94, de sorte que ces équipements de montage 91 reçoivent une puissance d'actionnement PACT qui équivaut à la puissance maximale disponible PMAX diminuée d'une puissance accessoire PACC, soit PACT=PMAX-PACC ; la puissance accessoire PACC correspondant à la puissance électrique demandée par les équipements accessoires 93, 94 ou la puissance nécessaire pour alimenter ces équipements accessoires 93, 94. Cette étape E3-2 est suivie d'une étape E3-3, ou étape « DISTRIBUTION PACT », au cours de laquelle la puissance d'actionnement PACT est répartie sur le ou les équipements de montage 91, de sorte que chaque équipement de montage reçoit une puissance électrique qui est inférieure ou égale à cette puissance d'actionnement PACT. Si un seul équipement de montage est en jeu (par exemple la centrale hydraulique de pliage/dépliage) alors toute la puissance d'actionnement PACT est allouée à ce seul équipement de montage.

Si par contre, dans le mode brut MBRUT, lors de l'étape de sélection de configuration T3, la configuration de travail est sélectionnée alors est exécutée une étape E3-2, ou étape « DISTRIBUTION PMAX », au cours de laquelle la puissance maximale disponible PMAX est répartie sur les équipements d'actionnement 91, 92 (qui sont ici les équipements de travail 92) et sur les équipements accessoires 93, 94, de sorte que ces équipements de travail 92 reçoivent une puissance d'actionnement PACT qui équivaut à la puissance maximale disponible PMAX diminuée de la puissance accessoire PACC, soit PACT=PMAX-PACC. Cette étape E3-2 est suivie d'une étape E3-4, ou étape « DISTRIBUTION PACT », au cours de laquelle la puissance d'actionnement PACT est répartie sur les différents équipements de travail 92, de sorte que chaque équipement de travail reçoit une puissance électrique qui est inférieure ou égale à cette puissance d'actionnement PACT ce qui revient à, dans le mode de réalisation précédemment décrit, PLEV≤PACT, PDIST≤PACT et PORIEN≤PACT.

Dans le mode optimisé MOPT, les équipements d'actionnement 91, 92 peuvent être alimentées par une puissance d'actionnement PACT qui est équivalente :

- soit à la puissance maximale disponible PMAX si les conditions de coupure sont telles que tous les équipements accessoires 93, 94 sont coupés (donc éteints ou non alimentés), soit PACT=PMAX ;
- soit à la puissance maximale disponible PMAX diminuée de la puissance accessoire PACC, soit PACT=PMAX-PACC, cette puissance accessoire PACC correspondant à la puissance électrique demandée par les équipements accessoires 93, 94 qui ne sont pas coupés selon les conditions de coupure.

Ainsi, les équipements accessoires 93, 94 vont se répartir en :

- les équipements accessoires coupés, qui sont les équipements accessoires dont les conditions de coupure sont satisfaites de sorte que ces équipements accessoires coupés ne sont pas alimentés électriquement ; et
- les équipements accessoires non coupés, qui sont les équipements accessoires dont les conditions de coupure ne sont pas satisfaites de sorte que ces équipements accessoires non coupés sont pas alimentés électriquement.

Pour les équipements accessoires d'utilisateur 94, les équipements accessoires coupés sont les équipements accessoires pour lesquelles une classification « non essentielle » a été sélectionnée, et les équipements accessoires non coupés sont les équipements accessoires pour lesquelles une classification « essentielle » a été sélectionnée.

Ainsi, en référence à la figure 7, si lors de l'étape de sélection de configuration T2, la configuration de montage est sélectionnée, alors est exécutée une étape de vérification des conditions de coupure T4, ou étape « VERIFICATION COUPURE », dans laquelle les conditions de coupure des différents équipements accessoires 93, 94 sont contrôlées, ce qui conduit à deux situations.

Dans une première situation, si au moins une condition de coupure n'est pas satisfaite, alors est exécutée une étape E4-1, ou étape « DISTRIBUTION PMAX », au cours de laquelle la puissance maximale disponible PMAX est répartie sur les équipements d'actionnement 91, 92 (qui sont ici les équipements de montage 91) et sur le ou les équipements accessoires non coupés, de sorte que ces équipements de montage 91 reçoivent une puissance d'actionnement PACT qui équivaut à la puissance maximale disponible PMAX diminuée de la puissance accessoire PACC, soit PACT=PMAX-PACC. Cette étape E4-1 est suivie d'une étape E4-3, ou étape « DISTRIBUTION PACT », au cours de laquelle la puissance d'actionnement PACT est répartie sur le ou les équipements de montage 91, de sorte que chaque équipement de montage reçoit une puissance électrique qui est inférieure ou égale à cette puissance d'actionnement PACT. Si un seul équipement de montage est en jeu (par exemple la centrale hydraulique de pliage/dépliage) alors toute la puissance d'actionnement PACT est allouée à ce seul équipement de montage.

Dans une seconde situation, si par contre toutes les conditions de coupure sont satisfaites, alors est exécutée une étape E4-2, ou étape « DISTRIBUTION PMAX », au cours de laquelle la puissance maximale disponible PMAX est répartie uniquement sur les équipements d'actionnement 91, 92 (qui sont ici les équipements de montage 91), de sorte que ces équipements de montage 91 reçoivent une puissance d'actionnement PACT qui équivaut à la puissance maximale disponible PMAX, soit PACT=PMAX. Cette étape E4-2 est suivie d'une étape E4-4, ou étape « DISTRIBUTION PACT », au cours de laquelle la puissance d'actionnement PACT est répartie sur le ou les équipements de montage 91, de sorte que chaque équipement de montage reçoit une puissance électrique qui est inférieure ou égale à cette puissance maximale disponible PMAX. Si un seul équipement de montage est en jeu, alors toute la puissance maximale disponible PMAX est allouée à ce seul équipement de montage.

De la même manière, si lors de l'étape de sélection de configuration T2, la configuration de travail est sélectionnée, alors est exécutée une étape de vérification des conditions de coupure T5, ou étape « VERIFICATION COUPURE », dans laquelle les conditions de coupure des différents équipements accessoires 93, 94 sont contrôlées, ce qui conduit à deux situations.

Dans une première situation, si au moins une condition de coupure n'est pas satisfaite, alors est exécutée une étape E5-1, ou étape « DISTRIBUTION PMAX », au cours de laquelle la puissance maximale disponible PMAX est répartie sur les équipements d'actionnement 91, 92 (qui sont ici les équipements de travail 92) et sur le ou les équipements accessoires non coupés, de sorte que ces équipements de travail 92 reçoivent une puissance d'actionnement PACT qui équivaut à la puissance maximale disponible PMAX diminuée de la puissance accessoire PACC, soit PACT=PMAX-PACC.

Dans une seconde situation, si par contre toutes les conditions de coupure sont satisfaites, alors est exécutée une étape E5-2, ou étape « DISTRIBUTION PMAX », au cours de laquelle la puissance maximale disponible PMAX est répartie uniquement sur les équipements d'actionnement 91, 92 (qui sont ici les équipements de travail 92), de sorte que ces équipements de travail 92 reçoivent une puissance d'actionnement PACT qui équivaut à la puissance maximale disponible PMAX, soit PACT=PMAX.

L'étape E5-1 est suivie d'une étape de sélection de schéma T6, ou étape « SELECTION SCHEMA », et de même l'étape E5-1 est suivie d'une étape de sélection de schéma T7, ou étape « SELECTION SCHEMA ».

L'étape de sélection de schéma T6 ou T7 est une étape au cours de laquelle s'opère une sélection d'un schéma de répartition de la puissance d'actionnement PACT sur les différents équipements de travail 92, parmi les deux schémas de répartition suivants :

- un premier schéma SCH1 dans lequel les équipements de travail 92 sont activés et donc alimentés de manière séquentielle (c'est-à-dire les uns à la suite des autres, de manière non combinée), de sorte que chaque équipement de travail est alimenté, lorsque activé, par la puissance d'actionnement PACT ; et
- un second schéma SCH2 dans lequel les équipements de travail 92 sont activés et donc alimentés en simultané (c'est-à-dire les uns en même temps que les autres, de manière combinée), de sorte que tous les équipements de travail 92 sont alimentées ensemble par la puissance d'actionnement PACT.

Ainsi, si le premier schéma SCH1 est sélectionné lors de l'étape de sélection de schéma T6, alors est exécutée une étape E6-1, ou étape « DISTRIBUTION PACT », au cours de laquelle la puissance d'actionnement PACT (avec pour rappel PACT=PMAX-PACC) est allouée intégralement et de manière séquentielle à chaque équipement de travail lorsqu'activé, de sorte que chaque équipement de travail reçoit, lorsqu'il est activé, une puissance électrique qui est inférieure ou égale à cette puissance d'actionnement PACT. Par contre, si le second schéma SCH2 est sélectionné lors de l'étape de sélection de schéma T6, alors est exécutée une étape E6-2, ou étape « DISTRIBUTION PACT », au cours de laquelle la puissance d'actionnement PACT (avec pour rappel PACT=PMAX-PACC) est répartie sur les différents équipements de travail 92 qui sont activés (et donc demandeurs en énergie) de manière combinée.

De même, si le premier schéma SCH1 est sélectionné lors de l'étape de sélection de schéma T7, alors est exécutée une étape E7-1, ou étape « DISTRIBUTION PACT », au cours de laquelle la puissance d'actionnement PACT (avec pour rappel PACT=PMAX) est allouée intégralement et de manière séquentielle à chaque équipement de travail lorsqu'activé, de sorte que chaque équipement de travail reçoit, lorsqu'il est activé, une puissance électrique qui est inférieure ou égale à cette puissance d'actionnement PACT. Par contre, si le second schéma SCH2 est sélectionné lors de l'étape de sélection de schéma T7, alors est exécutée une étape E7-2, ou étape « DISTRIBUTION PACT », au cours de laquelle la puissance d'actionnement PACT (avec pour rappel PACT=PMAX) est répartie sur les différents équipements de travail 92 qui sont activés (et donc demandeurs en énergie) de manière combinée.

Selon une possibilité, est mis en œuvre un stockage dans une mémoire d'une pluralité de modes de répartition préférentielle, chaque mode de répartition préférentielle étant associé à des pourcentages de répartition de la puissance d'actionnement PACT sur les différents équipements de travail 92 dans le second schéma, avec par exemple une répartition comme suit :

$$PACT=PLEV+PDIS+PORIEN,$$

avec PLEV=q1.PACT, PDIS=q2.PACT et PORIEN=q3.PACT,
où q1, q2 et q3 sont des quantièmes ou pourcentages de répartition, avec q1+q2+q3=1.

Chaque mode de de répartition préférentielle est ainsi associé à différents quantièmes ou pourcentages de répartition q1, q2 et q3. Ces modes de répartition sont mis en oeuvre si la puissance d'actionnement PACT est inférieure à la somme des puissances demandées par les équipements de travail 92. En effet, si la puissance d'actionnement PACT est supérieure ou égale à la somme des puissances demandées par les équipements de travail 92, alors tous les équipements de travail 92 peuvent être alimentés à leur pleine puissance.

Aussi, le procédé de répartition F peut mettre en œuvre une étape de sélection d'un mode de répartition MREP, ou étape « SELECTION MODE DE REPARTITION », de sorte que l'étape E6-2 ou l'étape E7-2 exécute une répartition de la puissance d'actionnement PACT sur les différents équipements de travail 92 conformément au mode de répartition préférentielle sélectionné.

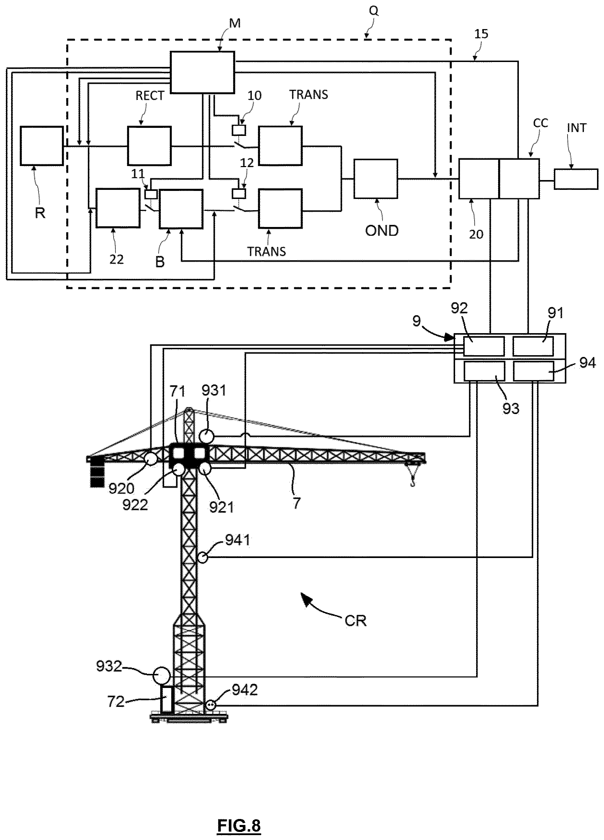

La suite de la description concerne la grue G qui comprend les équipements électriques 9 alimentés électriquement, via le circuit de conversion Q présenté à la figure 8, par la source d'alimentation primaire R apte à fournir la puissance primaire PR et la source d'alimentation secondaire rechargeable B apte à fournir la puissance secondaire PB.

Cette grue G comprend :

- une unité de surveillance M pour surveiller la puissance générale demandée PGEN qui correspond pour rappel à la puissance demandée par l'ensemble des équipements électriques 9 et le niveau de charge NC de la source d'alimentation secondaire rechargeable B, et
- l'unité de contrôle/commande CC raccordée à l'unité de surveillance M et au circuit de conversion Q, et configurée pour mettre en œuvre le procédé P de gestion d'alimentation électrique de la figure 6 précédemment décrit.

Il peut y avoir une interface électrique de recharge 22 entre la source d'alimentation primaire R et la source d'alimentation secondaire rechargeable B destinée à adapter la tension fournie par la source d'alimentation primaire R à une tension de recharge de la source d'alimentation secondaire rechargeable B. L'interface électrique de recharge 22 permet de recharger la source d'alimentation secondaire rechargeable B quand la source d'alimentation primaire R est raccordée et que la consommation de puissance électrique de la grue G est inférieure à la puissance primaire PR fournie par la source d'alimentation primaire R.

L'unité de contrôle/commande CC est également configurée pour la mise en oeuvre du procédé de répartition F de la figure 7 pour répartir la puissance maximale disponible PMAX sur les équipements électriques 9 de la grue G.

Aussi, cette unité de contrôle/commande CC est raccordée, d'une part, à une interface utilisateur INT permettant une sélection entre le mode brut MBRUT et le mode optimisé MOPT et, d'autre part, à un circuit électrique raccordant l'au moins une source d'alimentation aux équipements électriques 9 pour contrôler une répartition de la puissance maximale disponible PMAX selon le mode sélectionné parmi le mode brut MBRUT et le mode optimisé MOPT.

Selon une possibilité, la source d'alimentation primaire R délivre une tension d'alimentation primaire de type monophasée ou triphasée, par exemple en 230 ou 400 volts, et le circuit de conversion Q assure une conversion de ladite tension d'alimentation primaire en une tension d'alimentation triphasée. La tension d'alimentation triphasée peut être obtenue en assemblant trois convertisseurs monophasés couplés ou synchronisés ensemble pour générer une tension d'alimentation triphasée.

L'unité de surveillance M peut être un microcontrôleur et le circuit de conversion Q peut être un convertisseur électrique AC/AC comprenant un redresseur RECT et un onduleur OND comme le montre la figure 8, le redresseur RECT servant à convertir une tension alternative en provenance de la source d'alimentation primaire R en une tension continue pouvant être injectée à l'entrée d'un composant électrique élévateur TRANS destiné à élever la valeur du signal électrique comme un transformateur électrique par exemple, et l'onduleur OND servant à convertir la tension continue en sortie du composant élévateur TRANS ou bien de la source d'alimentation secondaire rechargeable B en une tension alternative destinée à alimenter un circuit électrique d'interface 20 précédant l'interface utilisateur INT.

Selon un mode de réalisation, l'unité de surveillance M sélectionne la source d'alimentation parmi la source d'alimentation primaire R et la source d'alimentation secondaire rechargeable B grâce à une mise en marche ou une mise à l'arrêt d'interrupteurs électriques 10, 11, 12. Les interrupteurs électriques 10, 11, 12 présentés à la figure 8 peuvent désigner des relais électromécaniques par exemple.

Si l'interrupteur 10 est fermé, alors on active le transfert de puissance de la source d'alimentation primaire R vers les équipements électriques 9 de la grue G. Si l'interrupteur 11 est fermé, alors on active le transfert de puissance de la source d'alimentation primaire R vers la source d'alimentation secondaire rechargeable B, autrement dit on recharge la source d'alimentation secondaire rechargeable B. Si l'interrupteur 12 est fermé, alors on active le transfert de puissance de la source d'alimentation secondaire rechargeable B vers les équipements électriques 9 de la grue G.

Le circuit de conversion Q peut également comprendre au moins un variateur de fréquence non représenté sur la figure 8 ainsi qu'un composant de mesure de courant connecté à la sortie de la source d'alimentation secondaire rechargeable comme un shunt électrique non représenté sur la figure 8.

La grue G comprend en outre l'interface utilisateur INT reliée à l'unité de contrôle

- commande CC pour :
- sélectionner le sous-mode de gestion parmi les sous-modes de gestion précédemment décrits qui sont le sous-mode automatique « AUTO », le sous-mode économique « ECO » et le sous-mode extrême « EXTR » ;
- sélectionner entre le mode brut « MBRUT » et le mode optimisé « MOPT » ;
- sélectionner la classification des équipements accessoires d'utilisateur 94 parmi la classification « non essentielle » et la classification « essentielle » ;
- sélectionner le schéma de répartition parmi le premier schéma SCH1 et le second schéma SCH2 ;
- sélectionner un mode de répartition préférentielle parmi les modes de répartition préférentielle stockée dans la mémoire.

L'unité de contrôle-commande CC peut être connectée à l'unité de surveillance M par un bus de communication 15 afin que l'unité de contrôle-commande CC puisse en permanence recevoir des informations de grandeurs électriques de la part de l'unité de surveillance M comme une tension d'entrée du redresseur RECT ou bien encore une tension de sortie de l'onduleur OND, afin que l'unité de contrôle-commande CC puisse ajuster des paramètres du circuit de conversion Q tel que la mise en marche ou à l'arrêt des interrupteurs électriques 10, 11, 12 par exemple.

L'unité de contrôle-commande CC peut en outre recevoir de la part de l'unité de surveillance M le mode d'alimentation mis en œuvre par le procédé P de gestion d'alimentation électrique ou bien une valeur de la tension d'alimentation primaire.

L'unité de contrôle-commande CC peut transférer à l'unité de surveillance M la puissance primaire PR renseignée par un utilisateur dans l'interface utilisateur INT et qui peut être utilisée par l'unité de surveillance M pour le calcul de la puissance maximale disponible PMAX.

En outre, selon un mode de réalisation, l'unité de contrôle-commande CC est capable de retrouver le mode d'alimentation mis en œuvre par le procédé P de gestion d'alimentation électrique sur la base de l'état des interrupteurs électriques 10, 11, 12 ou bien sur la base d'une valeur de la tension primaire envoyée par l'unité de surveillance M via le bus de communication 15.

Selon une possibilité, l'unité de contrôle-commande CC calcule d'abord la puissance maximale disponible PMAX en fonction de la ou des sources d'alimentation fournissant la puissance électrique, ainsi que du mode d'alimentation mis en œuvre, puis l'unité de contrôle-commande CC gère la répartition de la puissance maximale disponible PMAX sur les différents équipements électriques 9 de la grue G.

Selon une possibilité, un utilisateur de la grue G par exemple un pilote de la grue G renseigne la puissance primaire PR, le sous-mode de gestion et un ou plusieurs modes de répartition préférentielle.

Selon une possibilité, l'unité de contrôle-commande CC indique à l'utilisateur de la grue G via l'interface utilisateur INT le niveau de charge NC de la source d'alimentation secondaire rechargeable B, le mode d'alimentation mis en oeuvre et une information de mise en veille si le système bascule en mode veille.

Le niveau de charge NC de la source d'alimentation secondaire rechargeable B est estimé par l'unité de contrôle-commande CC à partir par exemple d'un courant de charge et de décharge de la source d'alimentation secondaire rechargeable B, ainsi, l'unité de contrôle-commande CC peut par exemple connaitre la capacité de la batterie en Ah ou Wh. Un étalonnage peut être réalisé quand la source d'alimentation secondaire rechargeable B est complétement chargée.

**Revendications**

1. Procédé (P) de gestion d'alimentation électrique pour alimenter électriquement des équipements électriques (9) d'une grue (G), via un circuit de conversion (Q), à partir d'une source d'alimentation primaire (R) apte à fournir une puissance primaire (PR) et d'une source d'alimentation secondaire rechargeable (B) apte à fournir une puissance secondaire (PB), ledit procédé (P) de gestion d'alimentation électrique comprenant une surveillance d'une puissance générale demandée (PGEN) qui correspond à une puissance demandée par l'ensemble des équipements électriques (9), et une surveillance d'un niveau de charge (NC) de la source d'alimentation secondaire rechargeable (B),

   et dans lequel le procédé (P) de gestion d'alimentation électrique met en œuvre, en fonction de ladite puissance générale demandée (PGEN) et dudit niveau de charge (NC), au moins les modes de gestion suivants :

   - un mode de recharge (MCHARG) dans lequel la puissance générale demandée

(PGEN) est nulle et la source d'alimentation primaire (R) est disponible et connectée à la source d'alimentation secondaire rechargeable (B) pour la recharger selon son niveau de charge (NC) ;

- un mode mixte recharge/alimentation (MMIXT) dans lequel la puissance générale demandée (PGEN) est non nulle, et la source d'alimentation primaire (R) est disponible et connectée, d'une part, aux équipements électriques (9) pour les alimenter électriquement et, d'autre part, à la source d'alimentation secondaire rechargeable (B) pour la recharger selon le niveau de charge (NC) ;

- un mode d'alimentation principale (MPRINC) dans lequel la puissance générale demandée (PGEN) est non nulle, et seule la source d'alimentation primaire est connectée aux équipements électriques (9) pour les alimenter électriquement ;

- un mode d'alimentation hybride (MHYBR) dans lequel la puissance générale demandée (PGEN) est non nulle, et la source d'alimentation primaire (R) et la source d'alimentation secondaire rechargeable (B) sont toutes deux connectées aux équipements électriques (9) pour les alimenter électriquement ; et

- un mode d'alimentation autonome (MAUTON) dans lequel la puissance générale demandée (PGEN) est non nulle, et seule la source d'alimentation secondaire rechargeable (B) est connectée aux équipements électriques (9) pour les alimenter électriquement selon le niveau de charge (NC) ;

dans lequel les équipements électriques (9) sont alimentées par une puissance maximale disponible (PMAX) qui correspond au minimum entre une puissance de conversion maximale (PCONV) et une puissance source (PS), où la puissance de conversion maximale (PCONV) correspond à une puissance maximale pouvant être délivrée en sortie du circuit de conversion (Q) et où la puissance source (PS) correspond à :

- la somme de la puissance secondaire (PB) et de la puissance primaire (PR) dans le mode d'alimentation hybride (MHYBR),
- la puissance secondaire (PB) dans le mode d'alimentation autonome (MAUTON);
- la puissance primaire (PR) dans le mode d'alimentation principale (MPRINC); et
- la puissance primaire (PR) moins une puissance de recharge (PCH) servant à recharger la source d'alimentation secondaire rechargeable (B) dans le mode mixte recharge/alimentation (MMIXT);

ledit procédé (P) de gestion d'alimentation étant **caractérisé en ce qu'**il met en œuvre, dans le mode d'alimentation autonome (MAUTON) et dans le mode d'alimentation hybride (MHYBR), une adaptation de la puissance secondaire (PB) en fonction au moins du niveau de charge (NC), ladite puissance secondaire (PB) étant inférieure ou égale à une puissance maximale secondaire (PBMAX) qui correspond à une puissance maximale pouvant être délivrée par la source d'alimentation secondaire rechargeable (B) ;

et **en ce qu'**il met en oeuvre une sélection, dans le mode d'alimentation hybride (MHYBR) et dans le mode d'alimentation autonome (MAUTON), d'un sous-mode de gestion parmi plusieurs sous-modes de gestion comprenant au moins :

- un sous-mode automatique (AUTO) dans lequel la puissance secondaire (PB) est contrôlée pour correspondre à ka fois la puissance maximale secondaire (PBMAX), où ka est un coefficient qui est inférieur ou égal à 1 et qui diminue avec le niveau de charge (NC) jusqu'à ce que le niveau de charge (NC) passe en-dessous d'un seuil bas (SB) ;

- un sous-mode économique (ECO) dans lequel la puissance secondaire (PB) est contrôlée pour correspondre à ke fois la puissance maximale secondaire (PBMAX), où ke est un coefficient inférieur à ka et qui diminue avec le niveau de charge (NC) jusqu'à ce que le niveau de charge (NC) passe en-dessous d'un seuil bas (SB).

2. Procédé (P) de gestion d'alimentation électrique selon la revendication 1, dans lequel :

- dans le sous-mode automatique (AUTO), le coefficient ka est égal à kamax tant que le niveau de charge (NC) de la source d'alimentation secondaire rechargeable est au-dessus d'un seuil haut (SH), puis le coefficient ka est égal à kamin lorsque le niveau de charge (NC) est compris entre le seuil bas (SB) et le seuil haut (SH), et enfin le coefficient ka est nul lorsque le niveau de charge (NC) de la source d'alimentation secondaire rechargeable est en-dessous du seuil bas (SB), où kamax est supérieur kamin ; et

- dans le sous-mode économique (ECO), le coefficient ke est égal à kemax tant que le niveau de charge (NC) de la source d'alimentation secondaire rechargeable (B) est au-dessus du seuil haut (SH), puis le coefficient ke est égal à kemin lorsque le niveau de charge (NC) de la source d'alimentation secondaire rechargeable (B) est compris entre le seuil bas (SB) et le seuil haut (SH), et enfin le coefficient ke est nul lorsque le niveau de charge (NC) de la source d'alimentation secondaire rechargeable (B) est en-dessous du seuil bas (SB), où kemax est supérieur kemin, kamax est supérieur à kemax et kamin est supérieur kemin.

3. Procédé (P) de gestion d'alimentation électrique selon la revendication 2, dans lequel kamax est compris entre 0,8 et 1, kamin est compris entre 0,5 et 0,7, kemax est compris entre 0,6 et 0,8 et kemin est compris entre 0,2 et 0,4.

4. Procédé (P) de gestion d'alimentation électrique selon les revendications 2 ou 3, dans lequel le seuil bas (SB) est compris entre 5 et 15 % d'une capacité de charge de la source d'alimentation secondaire rechargeable (B) et le seuil haut (SH) est compris entre 40 et 60 % d'une capacité de charge de la source d'alimentation secondaire rechargeable (B).

5. Procédé (P) de gestion d'alimentation électrique selon l'une quelconque des revendications précédentes, dans lequel, dans le mode d'alimentation autonome (MAUTON) et que ce soit dans le sous-mode automatique (AUTO) ou dans le sous-mode économique (ECO), le procédé (P) de gestion d'alimentation électrique passe automatiquement dans un mode de veille (MV) après que le niveau de charge (NC) de la source d'alimentation secondaire rechargeable (B) soit passé en-dessous du seuil bas (SB), où dans le mode de veille (MV) sont alimentés uniquement des équipements de sécurité prédéfinis parmi les équipements électriques (9) pour permettre une mise en sécurité de la grue (G).

6. Procédé (P) de gestion d'alimentation électrique selon la revendication 5, dans lequel, dans le mode de veille (MV), la puissance secondaire (PB) est contrôlée pour correspondre à la puissance maximale secondaire (PBMAX) afin d'alimenter les équipements de sécurité au moins le temps de la mise en sécurité de la grue (G).

7. Procédé (P) de gestion d'alimentation électrique selon l'une quelconque des revendications précédentes, dans lequel les sous-modes de gestion comprennent également un sous-mode extrême (EXTR) dans lequel la puissance secondaire (PB) correspond à la puissance maximale secondaire (PBMAX) quel que soit la valeur du niveau de charge (NC) de la source d'alimentation secondaire rechargeable (B).

8. Procédé (P) de gestion d'alimentation électrique selon les revendications 5 et 7, dans lequel, dans le sous-mode extrême (EXTR), lorsque le niveau de charge (NC) de la source d'alimentation secondaire rechargeable (B) est passé en-dessous du seuil bas (SB) alors sont alimentés uniquement les équipements de sécurité pour permettre une mise en sécurité de la grue.

9. Procédé (P) de gestion d'alimentation électrique selon l'une quelconque des revendications précédentes, dans lequel est mise en œuvre un procédé de répartition de la puissance maximale disponible (PMAX) sur les différents équipements électriques (9), quel que soit le mode de gestion parmi le mode d'alimentation hybride (MHYBR), le mode d'alimentation autonome (MAUTON), le mode d'alimentation principale (MPRINC) et le mode mixte recharge/alimentation (MMIXT).

10. Procédé (P) de gestion d'alimentation électrique selon la revendication 9, dans lequel le procédé de répartition de la puissance maximale comprend une étape de sélection entre :

    - un mode brut (MBRUT) dans lequel la puissance maximale disponible (PMAX) est répartie sur des équipements d'actionnement (91, 92) prédéfinis et sur des équipements accessoires (93, 94) prédéfinis parmi les équipements électriques (9), les équipements d'actionnement (91, 92) sont définis en fonction d'une configuration de la grue (G); et
    - un mode optimisé (MOPT) dans lequel la puissance maximale disponible (PMAX) est répartie sur les équipements d'actionnement (91, 92) prédéfinis, et aussi sur les équipements accessoires (93, 94) mais en fonction de conditions de coupure associées aux équipements accessoires (93, 94), de sorte que selon leurs conditions de coupure respectives les équipements accessoires (93, 94) sont alimentés ou non.

11. Procédé (P) de gestion d'alimentation électrique selon l'une quelconque des revendications précédentes, dans lequel, lorsque la puissance générale demandée (PGEN) est non nulle, les modes de gestion suivants sont automatiquement mis en œuvre :

    - le mode d'alimentation autonome (MAUTON) est automatiquement mis en œuvre si la source d'alimentation primaire (R) n'est pas disponible ;
    - le mode d'alimentation principale (MPRINC) ou le mode mixte recharge/alimentation (MMIXT) est automatiquement mis en œuvre en fonction du niveau de charge (NC) de la source d'alimentation secondaire rechargeable (B), si la source d'alimentation primaire (R) est disponible et si la puissance générale demandée (PGEN) est inférieure à la puissance primaire (PR) ;
- le mode d'alimentation hybride (MHYBR) est automatiquement mis en œuvre si la source d'alimentation primaire (R) est disponible et si la puissance générale demandée (PGEN) est supérieure à la puissance primaire (PR).

12. Grue (G) comprenant des équipements électriques (9) alimentés électriquement, via un circuit de conversion (Q), par une source d'alimentation primaire (R) apte à fournir une puissance primaire (PR) et une source d'alimentation secondaire rechargeable (B) apte à fournir une puissance secondaire (PB) **caractérisée en ce que** ladite grue (G) comprend une unité de surveillance (M) d'une puissance générale demandée (PGEN) qui correspond à une puissance demandée par l'ensemble des équipements électriques (9) et d'un niveau de charge (NC) de la source d'alimentation secondaire rechargeable (B), et **en ce qu'**elle comprend une unité de contrôle/commande (CC), raccordée à l'unité de surveillance (M) et au circuit de conversion (Q), et configurée pour mettre en œuvre le procédé (P) de gestion d'alimentation électrique conformément à l'une quelconque des revendications précédentes.

13. Grue (G) selon la revendication 12 dans laquelle les équipements électriques (9) comprennent des équipements de sécurité configurés pour permettre une mise en sécurité de la grue (G).

14. Grue (G) selon la revendication 12 ou 13, comprenant en outre une interface utilisateur (INT) reliée à l'unité de contrôle - commande (CC) pour sélectionner, dans le mode d'alimentation hybride (MHYBR), dans le mode d'alimentation autonome (MAUTON), dans le mode d'alimentation principale (MPRINC) et dans le mode mixte recharge/alimentation (MMIXT), un sous-mode de gestion parmi plusieurs sous-modes de gestion du procédé (P) de gestion d'alimentation électrique selon l'une quelconque des revendications 2 à 9.

**Patentansprüche**

1. Verfahren (P) zur Stromversorgungsverwaltung, um elektrische Ausrüstungen (9) eines Krans (G) über eine Wandlerschaltung (Q) ausgehend von einer Primärversorgungsquelle (R) mit Strom zu versorgen, die imstande ist, eine Primärleistung (PR) bereitzustellen, und einer wiederaufladbaren Sekundärversorgungsquelle (B), die imstande ist, eine Sekundärleistung (PB) bereitzustellen, wobei das Verfahren (P) zur Stromversorgungsverwaltung eine Überwachung einer angeforderten allgemeinen Leistung (PGEN), die einer von der Gesamtheit der elektrischen Ausrüstungen (9) angeforderten Leistung entspricht, und eine Überwachung eines Ladezustands (NC) der wiederaufladbaren Sekundärversorgungsquelle (B) umfasst, und wobei das Verfahren (P) zur Stromversorgungsverwaltung in Abhängigkeit von der angeforderten allgemeinen Leistung (PGEN) und dem Ladezustand (NC) mindestens die folgenden Verwaltungsmodi umsetzt:

- einen Lademodus (MCHARG), wobei die angeforderte allgemeine Leistung (PGEN) Null ist und die Primärversorgungsquelle (R) verfügbar und mit der wiederaufladbaren Sekundärversorgungsquelle (B) verbunden ist, um sie entsprechend ihrem Ladezustand (NC) zu laden;
- einen gemischten Lade-/Versorgungsmodus (MMIXT), bei dem die angeforderte allgemeine Leistung (PGEN) nicht Null ist und die Primärversorgungsquelle (R) verfügbar, und mit einerseits den elektrischen Ausrüstungen (9) verbunden ist, um sie mit Strom zu versorgen, und andererseits mit der wiederaufladbaren Sekundärversorgungsquelle (B), um sie entsprechend dem Ladezustand (NC) zu laden;
- einen Hauptversorgungsmodus (MPRINC), wobei die angeforderte allgemeine Leistung (PGEN) nicht Null ist und nur die Primärversorgungsquelle mit den elektrischen Ausrüstungen (9) verbunden ist, um sie mit Strom zu versorgen;
- einen Hybrid-Versorgungsmodus (MHYBR), wobei die angeforderte allgemeine Leistung (PGEN) nicht Null ist und die Primärversorgungsquelle (R) und die wiederaufladbare Sekundärversorgungsquelle (B) beide mit den elektrischen Ausrüstungen (9) verbunden sind, um sie mit Strom zu versorgen; und
- einen autonomen Versorgungsmodus (MAUTON), wobei die angeforderte allgemeine Leistung (PGEN) nicht Null ist und nur die wiederaufladbare Sekundärversorgungsquelle (B) mit den elektrischen Ausrüstungen (9) verbunden ist, um sie entsprechend dem Ladezustand (NC) mit Strom zu versorgen;
wobei die elektrischen Ausrüstungen (9) mit einer maximalen verfügbaren Leistung (PMAX) versorgt werden, die dem Minimum zwischen einer maximalen Umwandlungsleistung (PCONV) und einer Quellleistung (PS) entspricht, wobei die maximale Umwandlungsleistung (PCONV) einer maximalen Leistung entspricht, die am Ausgang der Wandlerschaltung (Q) abgegeben werden kann, und wobei die Quellleistung (PS) entspricht:

- der Summe der Sekundärleistung (PB) und der Primärleistung (PR) im Hybrid-Versorgungsmodus (MHYBR),
- der Sekundärleistung (PB) im autonomen Versorgungsmodus (MAUTON);
- der Primärleistung (PR) im Hauptversorgungsmodus (MPRINC); und
- der Primärleistung (PR) abzüglich einer Ladeleistung (PCH), die zum Laden der wiederaufladbaren Sekundärversorgungsquelle (B) im gemischten Lade-/Versorgungsmodus (MMIXT) dient;

wobei das Verfahren (P) zur Versorgungsverwaltung **dadurch gekennzeichnet ist, dass** es im autonomen Versorgungsmodus (MAUTON) und im Hybrid-Versorgungsmodus (MHYBR) eine Anpassung der Sekundärleistung (PB) in Abhängigkeit von mindestens dem Ladezustand (NC) umsetzt, wobei die Sekundärleistung (PB) kleiner oder gleich einer maximalen Sekundärleistung (PBMAX) ist, die einer maximalen Leistung entspricht, die von der wiederaufladbaren Sekundärversorgungsquelle (B) abgegeben werden kann;
und dadurch, dass es im Hybrid-Versorgungsmodus (MHYBR) und im autonomen Versorgungsmodus (MAUTON) eine Auswahl eines Verwaltungsteilmodus aus mehreren Verwaltungsteilmodi umsetzt, die mindestens umfassen:

- einen automatischen Teilmodus (AUTO), wobei die Sekundärleistung (PB) gesteuert wird, um dem ka-fachen der maximalen Sekundärleistung (PBMAX) zu entsprechen, wobei ka ein Koeffizient ist, der kleiner oder gleich 1 ist und mit dem Ladezustand (NC) abnimmt, bis der Ladezustand (NC) unter einen unteren Schwellenwert (SB) fällt;
- einen Öko-Teilmodus (ECO), wobei die Sekundärleistung (PB) gesteuert wird, um dem ke-fachen der maximalen Sekundärleistung (PBMAX) zu entsprechen, wobei ke ein Faktor kleiner als ka ist und mit dem Ladezustand (NC) abnimmt, bis der Ladezustand (NC) unter einen unteren Schwellenwert (SB) fällt.

2. Verfahren (P) zur Stromversorgungsverwaltung nach Anspruch 1, wobei:

- im automatischen Teilmodus (AUTO) der Koeffizient ka gleich kamax ist, solange der Ladezustand (NC) der wiederaufladbaren Sekundärversorgungsquelle über einem oberen Schwellenwert (SH) liegt, danach der Koeffizient ka gleich kamin ist, wenn der Ladezustand (NC) zwischen dem unteren Schwellenwert (SB) und dem oberen Schwellenwert (SH) liegt, und schließlich der Koeffizient ka Null ist, wenn der Ladezustand (NC) der wiederaufladbaren Sekundärversorgungsquelle unter dem unteren Schwellenwert (SB) liegt, wo kamax größer als kamin ist; und
- im Öko-Teilmodus (ECO) der Koeffizient ke gleich kemax ist, solange der Ladezustand (NC) der wiederaufladbaren Sekundärversorgungsquelle (B) über dem oberen Schwellenwert (SH) liegt, danach der Koeffizient ke gleich kemin ist, wenn der Ladezustand (NC) der wiederaufladbaren Sekundärversorgungsquelle (B) zwischen dem unteren Schwellenwert (SB) und dem oberen Schwellenwert (SH) liegt, und schließlich der Koeffizient ke gleich Null ist, wenn der Ladezustand (NC) der wiederaufladbaren Sekundärversorgungsquelle (B) unter dem unteren Schwellenwert (SB) liegt, wo kemax größer als kemin ist, kamax größer als kemax ist und kamin größer als kemin ist.

3. Verfahren (P) zur Stromversorgungsverwaltung nach Anspruch 2, wobei kamax zwischen 0,8 und 1, kamin zwischen 0,5 und 0,7, kemax zwischen 0,6 und 0,8 und kemin zwischen 0,2 und 0,4 liegt.

4. Verfahren (P) zur Stromversorgungsverwaltung nach Anspruch 2 oder 3, wobei der untere Schwellenwert (SB) zwischen 5 und 15 % einer Ladekapazität der wiederaufladbaren Sekundärversorgungsquelle (B) liegt und der obere Schwellenwert (SH) zwischen 40 und 60 % einer Ladekapazität der wiederaufladbaren Sekundärversorgungsquelle (B) liegt.

5. Verfahren (P) zur Stromversorgungsverwaltung nach einem der vorstehenden Ansprüche, wobei das Verfahren (P) zur Stromversorgungsverwaltung im autonomen Versorgungsmodus (MAUTON) und egal ob im automatischen Teilmodus (AUTO) oder im Öko-Teilmodus (ECO) automatisch in einen Standby-Modus (MV) wechselt, nachdem der Ladezustand (NC) der wiederaufladbaren Sekundärversorgungsquelle (B) unter den unteren Schwellenwert (SB) gefallen ist, wo im Standby-Modus (MV) nur vordefinierte Sicherheitsausrüstungen unter den elektrischen Ausrüstungen (9) versorgt werden, um eine Absicherung des Krans (G) zu ermöglichen.

6. Verfahren (P) zur Stromversorgungsverwaltung nach Anspruch 5, wobei im Standby-Modus (MV) die Sekundärleistung (PB) gesteuert wird, um der maximalen Sekundärleistung (PBMAX) zu entsprechen, um die Sicherheitsausrüstungen mindestens für die Zeit der Kransicherung (G) zu versorgen.

7. Verfahren (P) zur Stromversorgungsverwaltung nach einem der vorstehenden Ansprüche, wobei die Verwaltungsteilmodi auch einen extremen Teilmodus (EXTR) umfassen, bei dem die Sekundärleistung (PB) unabhängig vom Wert des Ladezustands (NC) der wiederaufladbaren Sekundärversorgungsquelle (B) der maximalen Sekundärleistung (PBMAX) entspricht.

8. Verfahren (P) zur Stromversorgungsverwaltung nach Anspruch 5 und 7, wobei im extremen Teilmodus (EXTR), wenn der Ladezustand (NC) der wiederaufladbaren sekundären Stromversorgungsquelle (B) unter den unteren Schwellenwert (SB) gefallen ist, dann nur die Sicherheitsausrüstungen versorgt werden, um eine Kransicherung zu ermöglichen.

9. Verfahren (P) zur Stromversorgungsverwaltung nach einem der vorstehenden Ansprüche, wobei ein Verfahren zur Verteilung der maximalen verfügbaren Leistung (PMAX) auf die verschiedenen elektrischen Ausrüstungen (9) unabhängig vom Verwaltungsmodus unter dem Hybrid-Versorgungsmodus (MHYBR), dem autonomen Versorgungsmodus (MAUTON), dem Hauptversorgungsmodus (MPRINC) und dem gemischten Lade-/Versorgungsmodus (MMIXT) umgesetzt wird.

10. Verfahren (P) zur Stromversorgungsverwaltung nach Anspruch 9, wobei das Verfahren zur Verteilung der maximalen Leistung einen Schritt zur Auswahl umfasst zwischen:

- einem Bruttomodus (MBRUT), wobei die maximale verfügbare Leistung (PMAX) auf vordefinierte Betätigungsausrüstungen (91, 92) und auf vordefinierte Zubehörausrüstungen (93, 94) unter den elektrischen Ausrüstungen (9) verteilt wird, wobei die Betätigungsausrüstungen (91, 92) in Abhängigkeit von einer Konfiguration des Krans (G) definiert sind; und
- einem optimierten Modus (MOPT), wobei die maximale verfügbare Leistung (PMAX) auf die vordefinierten Betätigungsausrüstungen (91, 92) und auch auf die Zubehörausrüstungen (93, 94) verteilt wird, jedoch in Abhängigkeit von den Abschaltbedingungen, die mit den Zubehörausrüstungen (93, 94) verknüpft sind, sodass die Zubehörausrüstungen (93, 94) entsprechend ihren jeweiligen Abschaltbedingungen versorgt werden oder nicht.

11. Verfahren (P) zur Stromversorgungsverwaltung nach einem der vorstehenden Ansprüche, wobei, wenn die angeforderte allgemeine Leistung (PGEN) nicht Null ist, die folgenden Verwaltungsmodi automatisch umgesetzt werden:

- der autonome Versorgungsmodus (MAUTON) wird automatisch umgesetzt, wenn die Primärversorgungsquelle (R) nicht verfügbar ist;
der Hauptversorgungsmodus (MPRINC) oder der gemischte Lade-/Versorgungsmodus (MMIXT) wird automatisch in Abhängigkeit vom Ladezustand (NC) der wiederaufladbaren Sekundärversorgungsquelle (B) umgesetzt, wenn die Primärversorgungsquelle (R) verfügbar ist und die angeforderte allgemeine Leistung (PGEN) niedriger als die Primärleistung (PR) ist;
- der Hybrid-Versorgungsmodus (MHYBR) wird automatisch umgesetzt, wenn die Primärversorgungsquelle (R) verfügbar ist und wenn die angeforderte allgemeine Leistung (PGEN) größer als die Primärleistung (PR) ist.

12. Kran (G), der elektrischen Ausrüstungen (9) umfasst, die über eine Wandlerschaltung (Q) von einer Primärversorgungsquelle (R) mit Strom versorgt werden, die imstande ist, eine Primärleistung (PR) bereitzustellen, und einer wiederaufladbaren Sekundärversorgungsquelle (B), die imstande ist, eine Sekundärleistung (PB) bereitzustellen, **dadurch gekennzeichnet, dass** der Kran (G) eine Überwachungseinheit (M) einer angeforderten allgemeinen Leistung (PGEN) umfasst, die einer von der Gesamtheit der elektrischen Ausrüstungen (9) angeforderten Leistung entspricht, und eines Ladezustands (NC) der wiederaufladbaren Sekundärversorgungsquelle (B) und dadurch, dass sie eine Kontroll-/Steuereinheit (CC) umfasst, die an die Überwachungseinheit (M) und an die Wandlerschaltung (Q) angeschlossen ist und konfiguriert ist, um das Verfahren (P) zur Stromversorgungsverwaltung nach einem der vorstehenden Ansprüche umzusetzen.

13. Kran (G) nach Anspruch 12, wobei die elektrischen Ausrüstungen (9) Sicherheitsausrüstungen umfassen, die konfiguriert sind, um eine Sicherung des Krans (G) zu ermöglichen.

14. Kran (G) nach Anspruch 12 oder 13, der weiter eine Benutzeroberfläche (INT) umfasst, die an die Kontroll-/Steuereinheit (CC) angeschlossen ist, um im Hybrid-Versorgungsmodus (MHYBR), im autonomen Versorgungsmodus (MAUTON), im Hauptversorgungsmodus (MPRINC) und im gemischten Lade-/Versorgungsmodus (MMIXT) einen Verwaltungsteilmodus unter mehreren Verwaltungsteilmodi des Verfahrens (P) zur Stromversorgungsverwaltung nach einem der Ansprüche 2 bis 9 auszuwählen.

**Claims**

1. A management method (P) for managing electrical power supply for electrically powering electrical equipment (9) of a crane (G), via a conversion circuit (Q), from a primary power supply source (R) capable of providing a primary power (PR) and from a rechargeable secondary power supply source (B) capable of providing a secondary power (PB), wherein said management method comprises a monitoring of a requested general power (PGEN) which corresponds to a power requested by all the electrical equipment (9) and a monitoring of a charge level (NC) of the rechargeable secondary power supply source (B),

   and wherein the management method (P) implements, depending on said requested general power (PGEN) and said charge level (NC), at least the following management modes:

   - a recharging mode (MCHARG) in which the requested general power (PGEN) is zero and the primary power supply source (R) is available and connected to the rechargeable secondary power supply source (B) to recharge it according to its charge level (NC);
   - a mixed recharging/powering mode (MMIXT) in which the requested general power (PGEN) is non-zero, and the primary power supply source (R) is available and connected, on the one hand, to the electrical equipment (9) to electrically power them and, on the other hand, to the rechargeable secondary power supply source (B) to recharge it depending on the charge level (NC);
   - a main power supply mode (MPRINC) in which the requested general power (PGEN) is non-zero, and only the primary power supply source is connected to the electrical equipment (9) to electrically power them;
   - a hybrid power supply mode (MHYBR) in which the requested general power (PGEN) is non-zero, and the primary power supply source (R) and the rechargeable secondary power supply source (B) are both connected to the electrical equipment (9) to electrically power them; and
   - an autonomous power supply mode (MAUTON) in which the requested general power (PGEN) is non-zero, and only the rechargeable secondary power supply source (B) is connected to the electrical equipment (9) to electrically power them according to the charge level (NC);

   wherein the electrical equipment (9) are powered by an available maximum power (PMAX) which corresponds to a minimum between a maximum conversion power (PCONV) and a source power (PS), wherein the maximum conversion power (PCONV) corresponds to a maximum power that can be delivered at the output of the conversion circuit (Q) and wherein the source power (PS) corresponds to:

   - the sum of the secondary power (PB) and of the primary power (PR) in the hybrid power supply mode (MHYBR);
   - the secondary power (PB) in the autonomous power supply mode (MAUTON);
   - the primary power (PR) in the main power supply mode (MPRINC); and
   - the primary power (PR) minus a recharging power (PCH) used to recharge the rechargeable secondary power supply source (B) in the mixed recharging/powering mode (MMIXT);

   the management method (P) being **characterized in that** it implements, in the autonomous power supply mode (MAUTON) and in the hybrid power supply mode (MHYBR), an adaptation of the secondary power (PB) as a function at least of the charge level (NC), said secondary power (PB) being lower than or equal to a secondary maximum power (PBMAX) which corresponds to a maximum power that can be delivered by the rechargeable secondary power supply source (B);

   and the management method (P) being **characterized in that** it implements a selection, in the hybrid power supply mode (MHYBR) and in the autonomous power supply mode (MAUTON), of a management sub-mode amongst several management sub-modes comprising at least:

   - an automatic sub-mode (AUTO) in which the secondary power (PB) is monitored so as to correspond to ka times the secondary maximum power (PBMAX), wherein ka is a coefficient that is less than or equal to 1 and which decreases with the charge level (NC) until the charge level (NC) drops below a low threshold (SB);
   - an economical sub-mode (ECO) in which the secondary power (PB) is monitored so as to correspond to ke times the secondary maximum power (PBMAX), wherein ke is a coefficient lower than ka and which decreases with the charge level (NC) until the charge level (NC) drops below a low threshold (SB).

2. The management method (P) according to claim 1, wherein:

   - in the automatic sub-mode (AUTO), the coefficient ka is equal to kamax as long as the charge level (NC) of the rechargeable secondary power supply source is above a high threshold (SH), then the coefficient ka is equal to kamin when the charge level (NC) is comprised between the low threshold (SB) and the high threshold (SH), and finally the coefficient ka is zero when the charge level (NC) of the rechargeable secondary power supply source is below the low threshold (SB), wherein kamax is higher than kamin; and
- in the economical sub-mode (ECO), the coefficient ke is equal to kemax as long as the charge level (NC) of the rechargeable secondary power supply source (B) is above the high threshold (SH), then the coefficient ke is equal to kemin when the charge level (NC) of the rechargeable secondary power supply source (B) is comprised between the low threshold (SB) and the high threshold (SH), and finally the coefficient ke is zero when the charge level (NC) of the rechargeable secondary power supply source (B) is below the low threshold (SB), wherein kemax is higher than kemin, kamax is higher than kemax and kamin is higher than kemin.

3. The management method (P) according to claim 2, wherein kamax is comprised between 0.8 and 1, kamin is comprised between 0.5 and 0.7, kemax is comprised between 0.6 and 0.8 and kemin is comprised between 0.2 and 0.4.

4. The management method (P) according to claim 2 or 3, wherein the low threshold (SB) is comprised between 5 and 15% of a charge capacity of the rechargeable secondary power supply source (B) and the high threshold (SH) is comprised between 40 and 60% of a charge capacity of the rechargeable secondary power supply source (B).

5. The management method (P) according to any one of the preceding claims, wherein, in the autonomous power supply mode (MAUTON) and whether in the automatic sub-mode (AUTO) or in the economical sub-mode (ECO), the management method (P) automatically switches into a standby mode (MV) after the charge level (NC) of the rechargeable secondary power supply source (B) drops below the low threshold (SB), wherein in the standby mode (MV) only predefined safety equipment amongst the electrical equipment (9) are powered to allow the crane (G) to be safe-guarded.

6. The management method (P) according to claim 5, wherein, in the standby mode (MV), the secondary power (PB) is monitored to match the secondary maximum power (PBMAX) in order to power the safety equipment at least while safeguarding the crane (G).

7. The management method (P) according to any one of the preceding claims, wherein the management sub-modes also comprise an extreme sub-mode (EXTR) in which the secondary power (PB) corresponds to the secondary maximum power (PBMAX) regardless of the value of the charge level (NC) of the rechargeable secondary power supply source (B).

8. The management method according to claims 5 and 7, wherein, in the extreme sub-mode (EXTR), when the charge level (NC) of the rechargeable secondary power supply source (B) drops below the low threshold (SB), then only the safety equipment are powered to allow the crane to be safe-guarded.

9. The management method (P) according to any one of the preceding claims, wherein an allocation method for allocating the available maximum power (PMAX) over the different electrical equipment (9) is implemented, regardless of the management mode amongst the hybrid power supply mode (MHYBR), the autonomous power supply mode (MAUTON), the main power supply mode (MPRINC) and the mixed recharging/powering mode (MMIXT).

10. The management method (P) according to claim 9, wherein the allocation method comprises a step of selecting between:

- a raw mode (MBRUT) in which the available maximum power (PMAX) is allocated over predefined actuation equipment (91, 92) and over predefined accessory equipment (93, 94) among the electrical equipment (9), the actuation equipment (91, 92) being defined according to a configuration of the crane (G); and
- an optimized mode (MOPT) in which the available maximum power (PMAX) is allocated over the predefined actuation equipment (91, 92) and also over the accessory equipment (93, 94) but according to cutoff conditions associated to the accessory equipment (93, 94), so that according to their respective cut-off conditions the accessory equipment (93, 94) are powered or not.

11. The management method (P) according to any one of the preceding claims, wherein, when the requested general power (PGEN) is non-zero, the following management modes are automatically implemented:

- the autonomous power supply mode (MAUTON) is automatically implemented if the primary power supply source (R) is not available;
- the main power supply mode (MPRINC) or the mixed recharging/powering mode (MMIXT) is automatically implemented according to the charge level (NC) of the rechargeable secondary power supply source (B), if the primary power supply source (R) is available and if the requested general power (PGEN) is lower than the primary power (PR);
- the hybrid power supply mode (MHYBR) is automatically implemented if the primary power supply source (R) is available and if the requested general power (PGEN) is higher than the primary power (PR).

12. A crane (G) comprising electrical equipment (9) electrically powered, via a conversion circuit (Q), by a primary power supply source (R) capable of providing a primary power (PR) and a rechargeable secondary power supply source (B) capable of providing a secondary power (PB), **characterized in that** the said crane (G) comprises a monitoring unit (M) for monitoring a requested general power (PGEN) which corresponds to a power requested by all the electrical equipment (9) and a charge level (NC) of the rechargeable secondary power supply source (B), and **characterized in that** the said crane (G) comprises a control/command unit (CC), connected to the monitoring unit (M) and to the conversion circuit (Q), and configured to implement the management method (P) in accordance with any one of the preceding claims.

13. The crane (CR) according to claim 12, wherein the electrical equipment (9) comprise safety equipment configured to allow the crane (G) to be safe-guarded.

14. The crane (G) according to claim 12 or 13, further comprising a user interface (INT) connected to the control - command unit (CC) to select, in the hybrid power supply mode (MHYBR), in the autonomous power supply mode (MAUTON), in the main power supply mode (MPRINC) and in the mixed recharging/powering mode (MMIXT), a management sub-mode amongst several management sub-modes of the management method (P) according to any one of claims 2 to 9.

MPRINC

R

PCONV   Q

PR   PMAX

PGEN

G

B   + −   NC

**FIG.1**

MHYBR

R

PCONV   Q

PR   PMAX

PGEN

G

PB

B   + −   NC

**FIG.2**

MAUTON

R

PCONV   Q

PMAX

PGEN

G

PB

B   + −   NC

**FIG.3**

MMIXT

PCONV     Q

R

PGEN

PR                              PMAX

PCH

B                    + ─        NC

**FIG.4**

G

MCHARG

PCONV     Q

R

PR

PCH

B                    + ─        NC

**FIG.5**

G

**FIG.6**

28

EP 4 056 516 B1

**FIG.7**

**FIG.8**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 202004500 U
- CN 110963412 A

- WO 2013001674 A1